# EUROPEAN PATENT APPLICATION

(11) **EP 4 770 353 A1**
(43) Date of publication of application: **01.07.2026**
(21) Application number: 24874926.9
(22) Date of filing: 30.09.2024
(51) Int. Cl.: H10H 29/01, H10D 86/00, H10H 20/851, H10H 20/831, G09F 9/33

(54) **DISPLAY DEVICE AND METHOD FOR MANUFACTURING DISPLAY DEVICE**

(30) Priority: 04.10.2023 KR 20230131942
(71) Applicant: Samsung Display Co., Ltd., Yongin-si, Gyeonggi-do 17113 (KR)
(72) Inventor: JEON, Hyung Il, Yongin-si Gyeonggi-do 17113 (KR); LEE, Kang Young, Yongin-si Gyeonggi-do 17113 (KR); CHOI, Jin Woo, Yongin-si Gyeonggi-do 17113 (KR); TAE, Chang Il, Yongin-si Gyeonggi-do 17113 (KR)
(74) Representative: Walaski, Jan Filip
(86) International application number: PCT/KR2024/014902
(87) International publication number: WO 2025/075370

(57) **Abstract**

A display apparatus includes a first substrate, a second substrate disposed on the first substrate, a light-emitting diode at least partially accommodated in the second substrate, a first electrode pad disposed on the second substrate and electrically connected to the light-emitting diode, a planarization insulating layer disposed on the second substrate and covering the first electrode pad, a transistor disposed on the planarization insulating layer and electrically connected to the first electrode pad, and a third substrate disposed on the transistor.

## Description

### Technical Field

Embodiments relate to display apparatuses and methods of manufacturing the same, and more particularly, to a flexible display apparatus and a method of manufacturing the flexible display apparatus.

### Background Art

Along with the development of display apparatuses that visually display electrical signals, various flat panel display apparatuses having excellent characteristics such as slim profile, light weight, and low power consumption are being introduced. For example, flexible display apparatuses that are foldable or rollable are being developed. Recently, research and development of various structures of display apparatuses such as a stretchable display apparatus are being actively conducted.

### Disclosure of Invention

### Technical Problem

Embodiments include a display apparatus and a method of manufacturing the display apparatus, e.g., a flexible display apparatus and a method of manufacturing the flexible display apparatus.

### Solution to Problem

In an embodiment of the disclosure, a display apparatus includes a first substrate, a second substrate disposed on the first substrate, a light-emitting diode at least partially accommodated in the second substrate, a first electrode pad disposed on the second substrate and electrically connected to the light-emitting diode, a planarization insulating layer disposed on the second substrate and covering the first electrode pad, a transistor disposed on the planarization insulating layer and electrically connected to the first electrode pad, and a third substrate disposed on the transistor.

In an embodiment, the transistor may include an active layer including a channel region, a drain region, and a source region, and a gate electrode overlapping the channel region.

In an embodiment, the gate electrode may be disposed between the light-emitting diode and the active layer.

In an embodiment, the gate electrode may be disposed between the third substrate and the active layer.

In an embodiment, the light-emitting diode may be spaced apart from the first substrate, and each of the first substrate and the second substrate may include a transparent material.

In an embodiment, the light-emitting diode may contact the first substrate, and the first substrate may include a transparent material.

In an embodiment, light transmittance of the first substrate may be different from light transmittance of the second substrate.

In an embodiment, the display apparatus may further include a first encapsulation layer disposed below the first substrate and supporting the first substrate.

In an embodiment, the display apparatus may further include a second encapsulation layer disposed on the third substrate.

In an embodiment of the disclosure, a method of manufacturing a display apparatus includes disposing a second substrate on a first substrate, disposing a light-emitting diode within the second substrate, curing the second substrate, disposing a first electrode pad on the second substrate to be electrically connected to the light-emitting diode, disposing a planarization insulating layer on the second substrate to cover the first electrode pad, disposing a transistor on the planarization insulating layer to be electrically connected to the first electrode pad, and disposing a third substrate on the transistor.

In an embodiment, the method may further include disposing the first substrate on a carrier substrate, and curing the first substrate.

In an embodiment, the method may further include attaching a carrier film onto the third substrate, removing the carrier substrate from the first substrate, attaching a first encapsulation layer to the first substrate, and removing the carrier film from the third substrate.

In an embodiment, the method may further include defining a first opening to pass through the first substrate, the second substrate, the planarization insulating layer, and the third substrate.

In an embodiment, the method may further include attaching a second encapsulation layer to the third substrate.

In an embodiment, the disposing the transistor may include disposing an active layer including a channel region, a drain region, and a source region, and disposing a gate electrode to overlap the channel region.

In an embodiment, the gate electrode may be disposed between the light-emitting diode and the active layer.

In an embodiment, the gate electrode may be disposed between the third substrate and the active layer.

In an embodiment, the disposing the light-emitting diode may include disposing the light-emitting diode to be spaced apart from the first substrate, and each of the first substrate and the second substrate may include a transparent material.

In an embodiment, the disposing the light-emitting diode may include disposing the light-emitting diode to contact the first substrate, and the first substrate may include a transparent material.

In an embodiment, light transmittance of the first substrate may be different from light transmittance of the second substrate.

### Advantageous Effects of Invention

In an embodiment, a display apparatus having improved stretchability due to a simplified stacking structure and being manufactured simply with highly reliability may be provided.

These effects are only examples, and the scope of the disclosure is not limited thereto.

### Brief Description of Drawings

FIG. 1 is a schematic perspective view of an embodiment of a display apparatus.
FIGS. 2A and 2B are perspective views showing the display apparatus of FIG. 1 stretched in a first direction.
FIG. 2C is a perspective view showing the display apparatus of FIG. 1 stretched in a second direction.
FIG. 2D is a perspective view showing the display apparatus of FIG. 1 stretched in the first direction and the second direction.
FIG. 2E is a perspective view showing the display apparatus of FIG. 1 stretched in a third direction.
FIG. 3 is a schematic plan view of an embodiment of a display apparatus.
FIG. 4A is an enlarged plan view of an embodiment of a region IV of FIG. 3, which is a portion of the display apparatus.
FIG. 4B is an enlarged plan view of an embodiment of a region IV of FIG. 3, which is a portion of the display apparatus.
FIG. 4C is an enlarged plan view of an embodiment of a region IV of FIG. 3, which is a portion of the display apparatus.
FIG. 5 is a schematic cross-sectional view of an embodiment of a first island portion and a first bridge portion disposed in a display area of the display apparatus.
FIGS. 6A through 6C are equivalent circuit diagrams of an embodiment of a sub-pixel of the display apparatus.
FIGS. 7A and 7B are schematic cross-sectional views of an embodiment of a light-emitting element of the display apparatus.
FIG. 8 is a schematic cross-sectional view of an embodiment of a portion of the display apparatus.
FIGS. 9A through 9H are schematic cross-sectional views of an embodiment of a portion of the display apparatus.
FIG. 10 is a schematic flowchart of an embodiment of a method of manufacturing a display apparatus.
FIG. 11 is a schematic cross-sectional view of an embodiment of a portion of the display apparatus.
FIGS. 12A through 12G are schematic perspective views of embodiments of an electronic apparatus including a display apparatus.

### Mode for the Invention

As the disclosure allows for various changes and numerous embodiments, particular embodiments will be illustrated in the drawings and described in detail in the written description. Hereinafter, effects and features of the disclosure and a method for accomplishing them will be described more fully with reference to the accompanying drawings, in which embodiments of the disclosure are shown. The disclosure may, however, be embodied in many different forms and should not be construed as limited to the embodiments set forth herein.

Embodiments will be described below in more detail with reference to the accompanying drawings. Those components that are the same as or are in correspondence with each other are rendered the same reference numeral regardless of the figure number, and redundant explanations are omitted.

It will be understood that although the terms "first," "second," etc. may be used herein to describe various components, these components should not be limited by these terms. These components are only used to distinguish one component from another.

As used herein, the singular forms "a," "an," and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "formed on" another layer, region, or component, it may be directly or indirectly formed on the other layer, region, or component. That is, for example, intervening layers, regions, or components may be present.

Sizes of elements in the drawings may be exaggerated or reduced for convenience of explanation. For example, since sizes and thicknesses of components in the drawings are arbitrarily illustrated for convenience of explanation, embodiments are not limited thereto.

When an illustrative embodiment may be implemented differently, a specific process order may be performed differently from the described order. For example, two consecutively described processes may be performed substantially at the same time or performed in an order opposite to the described order.

In the specification, "A and/or B" represents A or B, or A and B. The expression "at least one of A or B" indicates only A, only B, both A and B, or variations thereof.

It will also be understood that when a layer, region, or component is referred to as being "connected" or "coupled" to another layer, region, or component, it may be directly connected or coupled to the other layer, region, or/and component or intervening layers, regions, or components may be present. For example, when a layer, region, or component is referred to as being "electrically connected" or "electrically coupled" to another layer, region, or component, it may be directly electrically connected or coupled to the other layer, region, and/or component or intervening layers, regions, or components may be present.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

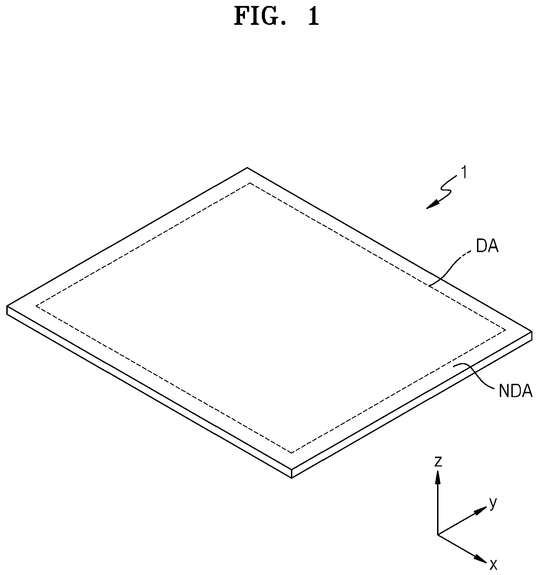

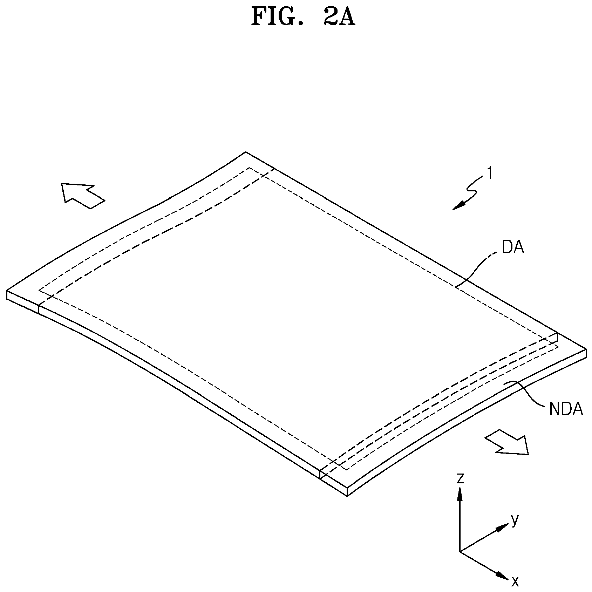

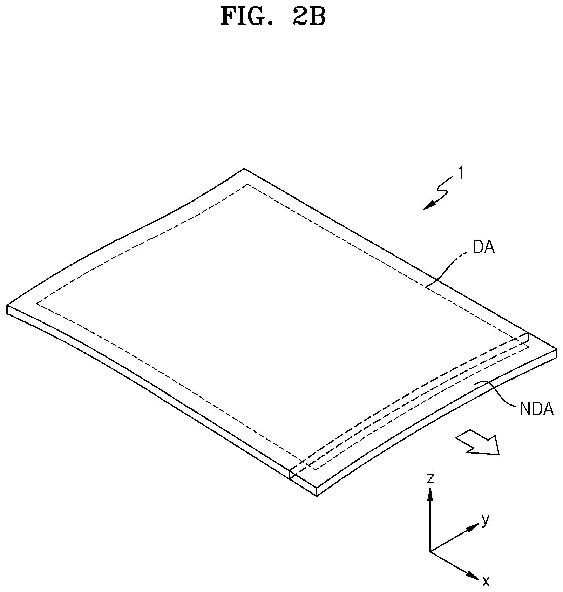

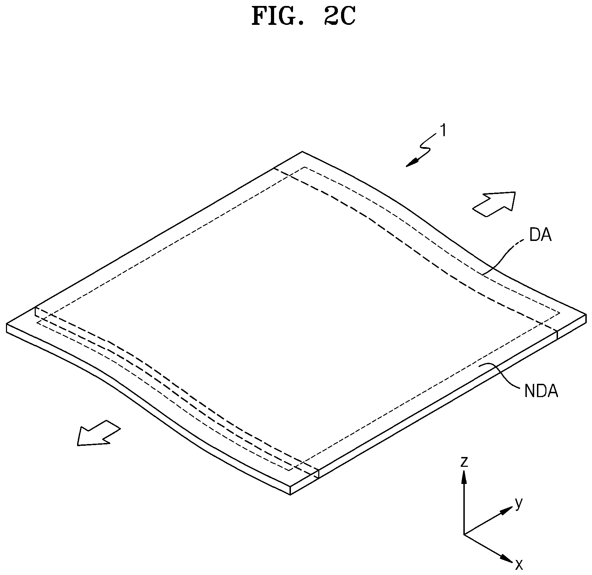

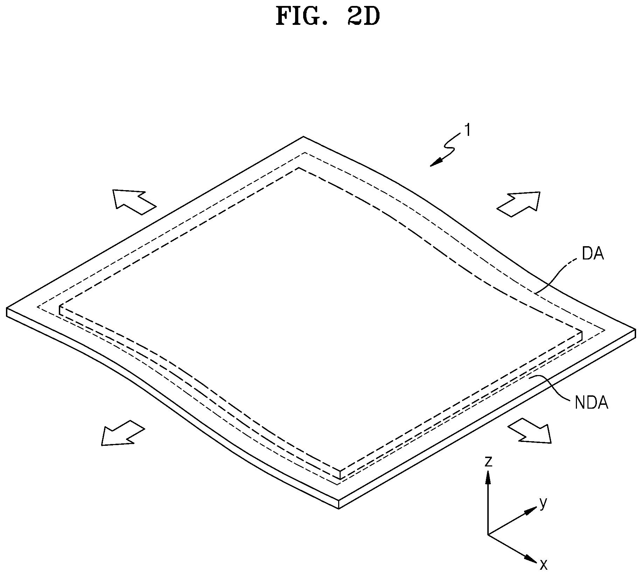

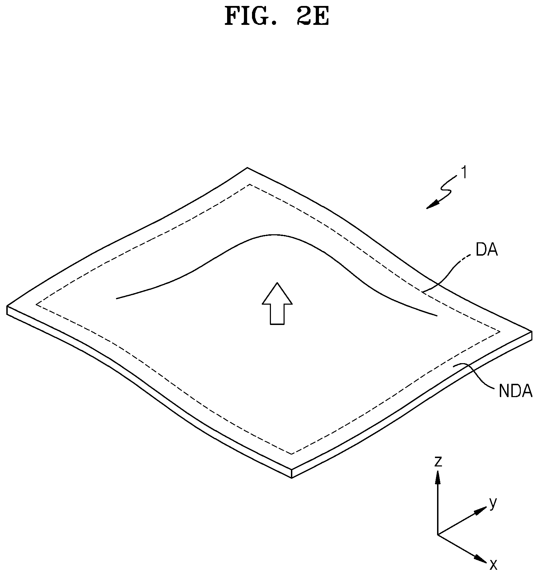

FIG. 1 is a schematic perspective view of an embodiment of a display apparatus 1. FIGS. 2A and 2B are perspective showing the display apparatus 1 of FIG. 1 stretched in a first direction. FIG. 2C is a perspective view showing the display apparatus 1 of FIG. 1 stretched in a second direction. FIG. 2D is a perspective view showing the display apparatus 1 of FIG. 1 stretched in the first direction and the second direction. FIG. 2E is a perspective view showing the display apparatus 1 of FIG. 1 stretched in a third direction.

Referring to FIG. 1, the display apparatus 1 may include a display area DA and a non-display area NDA. The display area DA may include a plurality of pixels. The display apparatus 1 may provide an image by light emitted by the plurality of pixels. The non-display area NDA may be disposed outside the display area DA. The non-display area NDA is an area in which no pixels are not disposed, and may surround the entirety of the display area DA.

The display apparatus 1 may be stretched or shrunk in various directions. The display apparatus 1 may be stretched in the first direction (e.g., an x direction and/or an - x direction) due to an external force applied by an external object or a user. In an embodiment, as shown in FIGS. 2A and 2B, the display area DA and/or the non-display area NDA of the display apparatus 1 may be stretched in the x direction (e.g., the x direction and/or the -x direction). In an embodiment, as shown in FIG. 2A, the display area DA and/or the non-display area NDA may be stretched in the x direction and the -x direction, or be stretched in the x direction with one side of the display apparatus 1 fixed as shown in FIG. 2B, for example.

The display apparatus 1 may be stretched in the second direction (e.g., a y direction and/or a -y direction) due to an external force exerted by an external object or a user. In an embodiment, as shown in FIG. 2C, the display area DA and/or the non-display area NDA of the display apparatus 1 may be stretched in the y direction and/or the -y direction. In another embodiment, the display area DA and/or the non-display area NDA may be stretched in the y direction or the -y direction with one side of the display apparatus 1 fixed.

The display apparatus 1 may be stretched in a plurality of directions, e.g., the first direction (e.g., the x direction and/or the -x direction) and the second direction (e.g., the y direction and/or the -y direction) due to an external force exerted by an external object or a portion of a human body. As shown in FIG. 2D, the display area DA and/or the non-display area NDA of the display apparatus 1 may be stretched in the ±x direction and the ±y direction.

The display apparatus 1 may be stretched in a third direction (e.g., a z direction or a -z direction) due to an external force exerted by an external object or a portion of a human body. In an embodiment, it is shown in FIG. 2E that a portion of the display apparatus 1, e.g., a partial region of the display area DA, protrudes in the z direction. In another embodiment, a portion of the display apparatus 1, e.g., a partial region of the display area DA, may protrude in the -z direction (or may be depressed in the z direction).

Although it is shown in FIGS. 2A through 2E that the display apparatus 1 is stretched in the first direction, the second direction, and/or the third direction, the disclosure is not limited thereto. In another embodiment, the display apparatus 1 may be transformed into various irregular shapes such as being bent or twisted along two or more axes.

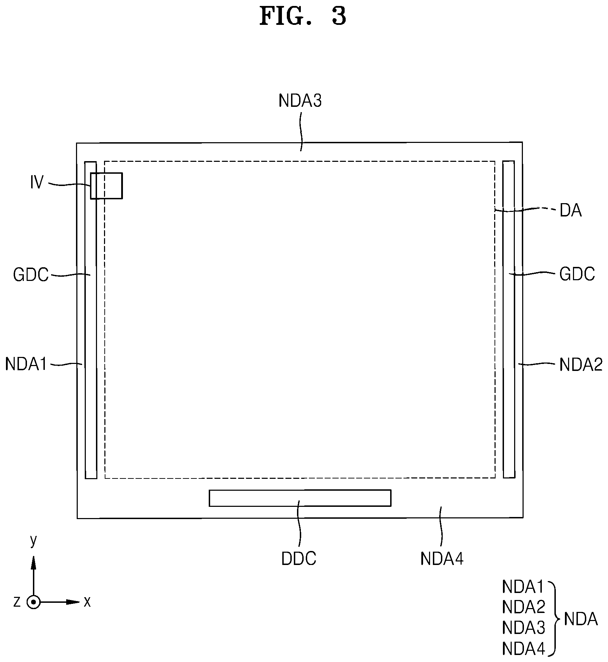

FIG. 3 is a schematic plan view of an embodiment of the display apparatus 1.

A plurality of pixels may be arranged in the display area DA of the display apparatus 1. Each pixel may include sub-pixels which emit light of different colors. A light-emitting element corresponding to each sub-pixel may be disposed in the display area DA. A circuit may be disposed in the non-display area NDA around the display area DA, where the circuit provides electrical signals to light-emitting elements and transistors electrically connected to the light-emitting elements arranged in the display area DA. Gate driving circuits GDC may be respectively arranged in a first non-display area NDA1 and a second non-display area NDA2, respectively, arranged on two opposite sides with the display area DA therebetween. The gate driving circuits GDC may include drivers which provide electrical signals to a gate electrode of each of the transistors electrically connected to the light-emitting elements. Although it is shown in FIG. 3 that the gate driving circuits GDC are respectively arranged in the first non-display area NDA1 and the second non-display area NDA2, the disclosure is not limited thereto. In another embodiment, a gate driving circuit GDC may be disposed in one of the first non-display area NDA1 and the second non-display area NDA2.

A data driving circuit DDC may be disposed in a third non-display area NDA3 and/or a fourth non-display area NDA4 each extending to the first non-display area NDA1 to the second non-display area NDA2. In an embodiment, it is shown in FIG. 3 that the data driving circuit DDC is disposed in the fourth non-display area NDA4. In another embodiment, data driving circuits DDC may be respectively arranged in the third non-display area NDA3 and the fourth non-display area NDA4.

Although it is shown in FIG. 3 that the data driving circuit DDC is disposed in the fourth non-display area NDA4 of the display apparatus 1, the disclosure is not limited thereto. In another embodiment, the display apparatus 1 may further include a flexible circuit board (not shown) electrically connected through a terminal portion (not shown) disposed in the fourth non-display area NDA4, and the data driving circuit DDC may be disposed on the flexible circuit board.

In some embodiments, an elongation rate of the non-display area NDA may be equal to or less than an elongation rate of the display area DA. In an embodiment, the elongation rate of the non-display area NDA may be different for each region thereof. In an embodiment, although the first non-display area NDA1, the second non-display area NDA2, and the third non-display area NDA3 may have substantially the same elongation rates, an elongation rate of the fourth non-display area NDA4 may be less than that of each of the first non-display area NDA1, the second non-display area NDA2, and the third non-display area NDA3, for example.

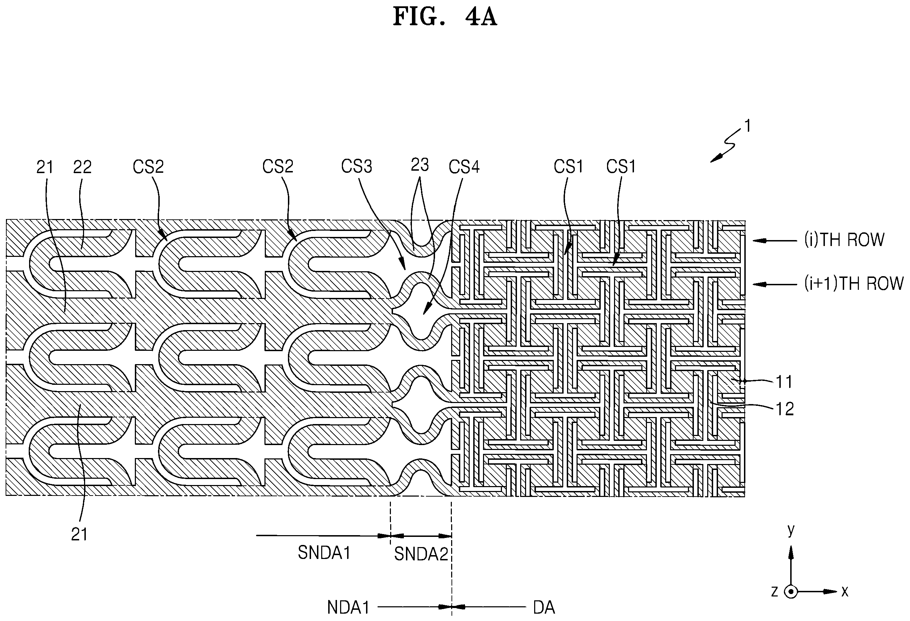

FIG. 4A is an enlarged plan view of an embodiment of a region IV of FIG. 3, which is a portion of the display apparatus 1.

Referring to FIG. 4A, the display apparatus 1 may include first island portions 11 and first bridge portions 12, where the first island portions 11 are spaced apart from each other in the first direction (e.g., the x direction or the -x direction) and the second direction (e.g., the y direction or the -y direction), and the first bridge portions 12 extend to adjacent first island portions 11.

Each first island portion 11 may be extended to a plurality of first bridge portions 12. In an embodiment, each first island portion 11 may be extended to four first bridge portions 12. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction), for example. In an embodiment, four first bridge portions 12 may be respectively extended to four lateral sides of the first island portion 11. The four first bridge portions 12 may be adjacent to corners of the first island portion 11, respectively.

First bridge portions 12 may be spaced apart from each other by a first opening CS1 defined between the first bridge portions 12. In an embodiment, first openings CS1 each having an approximate H-shape and first openings CS1 each having an approximate I-shape, which is rotated by 90 from the H shape, may be repeatedly and alternately defined in the first direction (e.g., the x direction or the -x direction) and the second direction (e.g., the y direction or the -y direction). Two opposite ends of each first bridge portion 12 may be extended to two adjacent first island portions 11, respectively, where one lateral side of each first bridge portion 12 may be spaced apart from one lateral side of an adjacent first island portion 11 and/or one lateral side of another first island portion 11 by the first opening CS1.

In a non-display area, e.g., the first non-display area NDA1 shown in FIG. 4A, the display apparatus 1 may include second island portions 21 spaced apart from each other and second bridge portions 22 extending to adjacent second island portions 21.

Each second island portion 21 may extend in the first direction (e.g., the x direction or the -x direction). The second island portions 21 may be spaced apart from each other in the second direction (e.g., the y direction or the -y direction) intersecting the first direction (e.g., the x direction or the -x direction). Each second island portion 21 may include drivers of the gate driving circuit GDC (refer to FIG. 2) described above with reference to FIG. 3.

The second bridge portion 22 may have a serpentine shape. A length of the second bridge portion 22 may be greater than a shortest distance between adjacent second island portions 21 in the second direction (e.g., the y direction or the -y direction). In an embodiment, the second bridge portion 22 may have an approximate omega Ω shape that is convex in the first direction (e.g., the x direction or the -x direction). The second bridge portions 22 may be arranged between adjacent second island portions 21 and may be spaced apart from each other.

The second bridge portions 22 between adjacent second island portions 21 may be spaced apart from each other by second openings CS2. Between adjacent second island portions 21, the second openings CS2 and the second bridge portions 22 may be alternately disposed and defined in the first direction (e.g., the x direction or the -x direction). The second openings CS2 may have the same shapes. Two opposite ends of each second bridge portion 22 may be extended to two adjacent second island portions 21, respectively, where one lateral side of each second bridge portion 22 may be spaced apart from one lateral side of an adjacent second island portion 21 and/or one lateral side of another second island portion 21 by the second opening CS2.

One second island portion 21 disposed in the first non-display area NDA1 may correspond to the first island portions 11 in a plurality of rows arranged in the display area DA. In an embodiment, one second island portion 21 disposed in the first non-display area NDA1 may correspond to the first island portions 11 in an i-th row and the first island portions 11 in an (i+1)th row in the display area DA (here, i is a positive number greater than 0), for example. Although it is shown in FIG. 4A that one second island portion 21 corresponds to two rows of the first island portions 11, the disclosure is not limited thereto. In another embodiment, one second island portion 21 disposed in the first non-display area NDA1 may correspond to n rows of the first island portions 11 arranged in the display area DA (here, n is a positive number equal to or greater than 3).

The non-display area, e.g., the first non-display area NDA1, may include a first sub-non-display area SNDA1 in which the second island portions 21 and the second bridge portions 22 are arranged, and a second sub-non-display area SNDA2 between the first sub-non-display area SNDA1 and the display area DA. Third bridge portions 23 may be arranged in the second sub-non-display area SNDA2, where the third bridge portions 23 extend the display area DA to the first sub-non-display area SNDA1. One end of each third bridge portion 23 may be extended to the second island portion 21 and/or the second bridge portion 22, and an opposite end of the third bridge portion 23 may be extended to the first island portion 11 and/or the first bridge portion 12.

The third bridge portion 23 may have a serpentine shape. In an embodiment, the shape of the third bridge portion 23 may be different from the shape of each of the first bridge portion 12 and the second bridge portion 22. In an embodiment, as shown in FIG. 4A, the third bridge portion 23 may have an approximate omega Ω shape that is convex in the second direction (e.g., the y direction or the -y direction). The third bridge portions 23 may have symmetrical structures, that is, one of adjacent third bridge portions 23 arranged in the second direction (e.g., the y direction or the -y direction) may be convex in the y direction and the other may be convex in the -y direction. A structure in which third openings CS3 and fourth openings CS4 of different shapes are repeatedly defined may be provided between the third bridge portions 23. A width of the third bridge portion 23 may be different from a width of the first bridge portion 12 and a width of the second bridge portion 22. In an embodiment, the width of the third bridge portion 23 may be greater than the width of the first bridge portion 12 and less than the width of the second bridge portion 22.

It is shown in FIG. 4A that the second island portion 21 and the second bridge portion 22 in the non-display area, e.g., the first non-display area NDA1, have different shapes from the shapes of the first island portion 11 and the first bridge portion 12 in the display area DA, respectively. In another embodiment, the second island portion 21 and the second bridge portion 22 in the non-display area may have the same shapes as the first island portion 11 and the first bridge portion 12 in the display area DA, respectively.

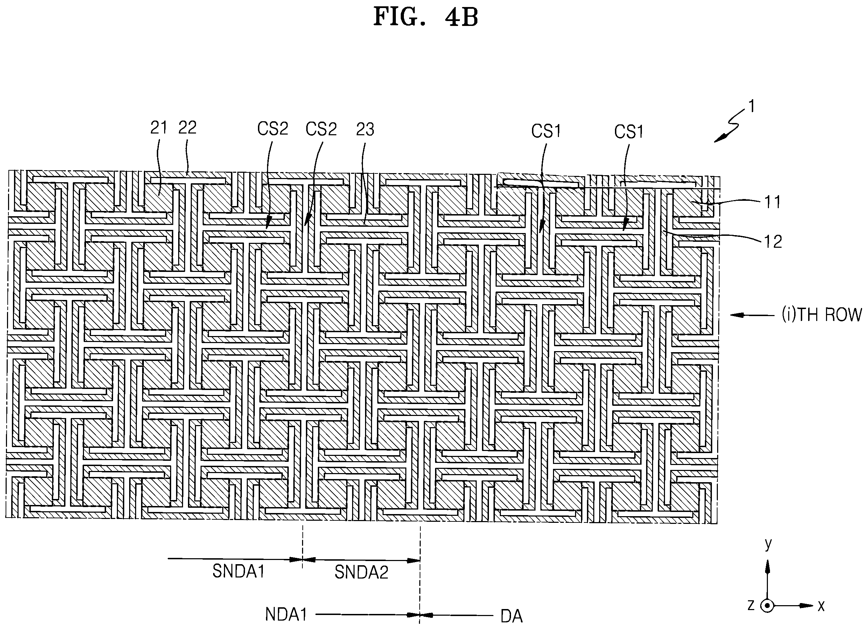

FIG. 4B is an enlarged plan view of an embodiment of a region IV of FIG. 3, which is a portion of the display apparatus 1.

Referring to FIG. 4B, the display apparatus 1 includes the first island portions 11 spaced apart from each other, and the first bridge portions 12 in the display area DA, where the first bridge portions 12 are spaced apart from each other by the first opening CS1 and connect adjacent first island portions 11 to each other. The structure of the display area DA in FIG. 4B may be the same as the structure of the display area DA described above with reference to FIG. 4A.

The display apparatus 1 may include second island portions 21 and second bridge portions 22 arranged in a non-display area, e.g., the first non-display area NDA1. In an embodiment, the second island portions 21 and the second bridge portions 22 may have substantially the same shapes as the first island portions 11 and the first bridge portions 12, respectively.

The second island portions 21 may be spaced apart from each other in the first direction (e.g., the x direction or the -x direction) and the second direction (e.g., the y direction or the -y direction) in the non-display area, e.g., the first non-display area NDA1. Each of the second bridge portions 22 may connect adjacent second island portions 21 to each other. The second bridge portions 22 may be spaced apart from each other by a second opening CS2 defined between the second bridge portions 22.

The second opening CS2 may have substantially the same shape as that of the first opening CS1. In an embodiment, the second opening CS2 having an approximate H shape and the second opening CS2 having an approximate I shape may be alternately and repeatedly defined in the non-display area, e.g., the first non-display area NDA1, for example. Two opposite ends of each second bridge portion 22 may be connected to two adjacent second island portions 21, respectively, where one lateral side of each second bridge portion 22 may be spaced apart from one lateral side of an adjacent second island portion 21 and/or one lateral side of another second island portion 21 by the second opening CS2.

Each second island portion 21 may be connected to four second bridge portions 22. Each second island portion 21 may include drivers of the gate driving circuit GDC (refer to FIG. 2) described above with reference to FIG. 3.

The second island portions 21 in one row arranged in the first non-display area NDA1 may correspond to the first island portions 11 in one row arranged in the display area DA. In an embodiment, the second island portions 21 arranged in the i-th row in the first direction (e.g., the x direction or the -x direction) in the first non-display area NDA1 may correspond to the first island portions 11 arranged in the same row, e.g., in the i-th row, in the display area DA (here, i is a positive number greater than 0), for example.

The display apparatus 1 may include third bridge portions 23 arranged in a second sub-non-display area SNDA2, where the third bridge portions 23 connect the display area DA to the first sub-non-display area SNDA1. The non-display area, e.g., the first non-display area NDA1, may include a first sub-non-display area SNDA1 in which the second island portions 21 and the second bridge portions 22 are arranged, and a second sub-non-display area SNDA2 including the third bridge portions 23 and disposed between the first sub-non-display area SNDA1 and the display area DA. Each third bridge portion 23 may be substantially the same as each first bridge portion 12 and each second bridge portion 22. In an embodiment, a width of the third bridge portion 23 may be the same as that of each of the first bridge portion 12 and the second bridge portion 22, for example.

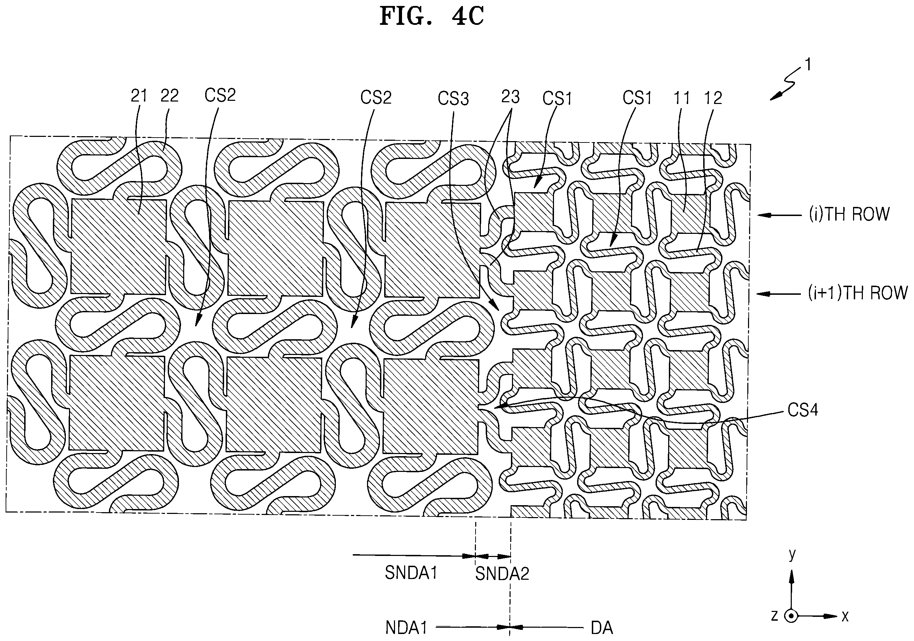

FIG. 4C is an enlarged plan view of an embodiment of a region IV of FIG. 3, which is a portion of the display apparatus 1.

Referring to FIG. 4C, the display apparatus 1 may include first island portions 11 and first bridge portions 12 in the display area DA, where the first island portions 11 are spaced apart from each other in the first direction (e.g., the x direction or the -x direction) and the second direction (e.g., the y direction or the -y direction), and the first bridge portions 12 extend to adjacent first island portions 11.

The first bridge portions 12 may be arranged apart from each other by a first opening CS1 defined between the first bridge portions 12. Each first bridge portion 12 may have a serpentine shape. In an embodiment, as shown in FIG. 4C, the first bridge portion 12 may have an approximately 'alphabet S' shape, for example.

Each first island portion 11 may be extended to a plurality of first bridge portions 12. In an embodiment, each first island portion 11 may be extended to four first bridge portions 12, for example. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction). Four first bridge portions 12 may be respectively extended to four lateral sides of the first island portion 11. The four first bridge portions 12 may be adjacent to corners of the first island portion 11, respectively.

The display apparatus 1 may include second island portions 21 and second bridge portions 22 extending to adjacent second island portions 21, where the second island portions 21 are spaced apart from each other in the first direction (e.g., the x direction or the -x direction) and the second direction (e.g., the y direction or the -y direction) in the non-display area NDA, e.g., in the first non-display area NDA1 shown in FIG. 4C.

The second bridge portions 22 may be arranged apart from each other by a second opening CS2 defined between the second bridge portions 22. Each second bridge portion 22 may have a serpentine shape. In an embodiment, as shown in FIG. 4C, the second bridge portion 22 may have an approximately 'alphabet S' shape. A size and/or a width of the second bridge portion 22 may be different from a size and/or a width of the first bridge portion 12, for example. In an embodiment, the size and/or the width of the second bridge portion 22 may be greater than the size and/or the width of the first bridge portion 12. A curvature radius of a round portion of the second bridge portion 22 may be different from a curvature radius of a round portion of the first bridge portion 12, for example. In an embodiment, the curvature radius of the round portion of the second bridge portion 22 may be greater than the curvature radius of the round portion of the first bridge portion 12, for example.

Each second island portion 21 may be extended to a plurality of second bridge portions 22. Each second island portion 21 may be extended to four second bridge portions 22. Two second bridge portions 22 may be respectively arranged on two opposite sides of the second island portion 21 in the first direction (e.g., the x direction or the -x direction), and the remaining two second bridge portions 22 may be respectively arranged on two opposite sides of the second island portion 21 in the second direction (e.g., the y direction or the -y direction). In an embodiment, four second bridge portions 22 may be respectively extended to four lateral sides of the second island portion 21. Each second bridge portion 22 may be extended to a central portion of each lateral side of the second island portion 21.

The second island portions 21 in one row arranged in the first non-display area NDA1 may correspond to the first island portions 11 in a plurality of rows arranged in the display area DA. In an embodiment, the second island portions 21 in one row arranged in the first non-display area NDA1 may correspond to the first island portions 11 in an i-th row and the first island portions 11 in an (i+1)th row in the display area DA (here, i is a positive number greater than 0). In another embodiment, the second island portions 21 in one row may correspond to n rows of the first island portions 11 (here, n is a positive number equal to or greater than 3).

The non-display area, e.g., the first non-display area NDA1, may include a first sub-non-display area SNDA1 in which the second island portions 21 and the second bridge portions 22 are arranged, and a second sub-non-display area SNDA2 between the first sub-non-display area SNDA1 and the display area DA. Third bridge portions 23 may be arranged in the second sub-non-display area SNDA2, where the third bridge portions 23 extend to the display area DA and the first sub-non-display area SNDA1. One end of each third bridge portion 23 may be extended to the second island portion 21, and an opposite end of the third bridge portion 23 may be extended to the first island portion 11. In an embodiment, one end of the third bridge portion 23 may be extended to the central portion of one lateral side of the second island portion 21, and an opposite end of the third bridge portion 23 may be extended to the central portion of one lateral side of the first island portion 11.

The third bridge portion 23 may have a serpentine shape. In an embodiment, the shape of the third bridge portion 23 may be different from the shape of each of the first bridge portion 12 and the second bridge portion 22. A width of the third bridge portion 23 may be different from that of each of the first bridge portion 12 and the second bridge portion 22. The width of the third bridge portion 23 may be greater than that of the first bridge portion 12 and less than the second bridge portion 22. In the second direction (e.g., the y direction or the -y direction), third openings CS3 and fourth openings CS4 having different shapes may be alternately defined between the third bridge portions 23.

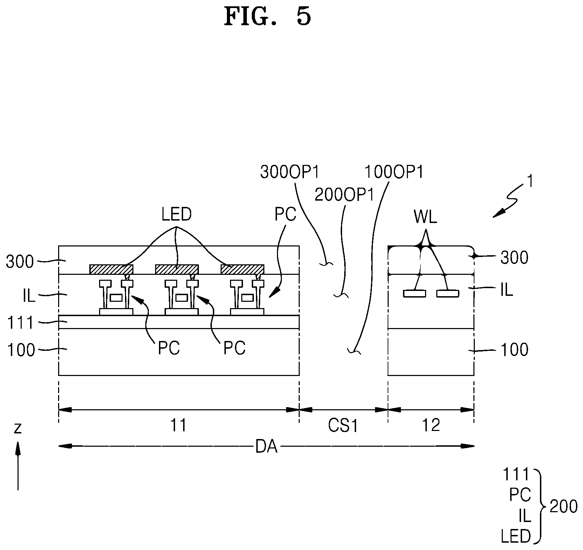

FIG. 5 is a schematic cross-sectional view of the first island portion 11 and the first bridge portion 12 arranged in the display area DA of the display apparatus 1.

Referring to FIG. 5, the first island portion 11 and the first bridge portion 12 arranged in the display area DA may be spaced apart from each other with the first opening CS1 therebetween. The first island portion 11 may include light-emitting elements LED and circuits, e.g., pixel driving circuit portions PC, electrically connected to the light-emitting elements LED and driving the light-emitting elements LED. The first bridge portion 12 may include wiring WL electrically connected to the pixel driving circuit portions PC respectively arranged on adjacent first island portions 11.

Regarding the first island portion 11, a buffer layer 111 including an inorganic insulating material may be disposed on a substrate 100, and the pixel driving circuit portions PC may be arranged on the buffer layer 111. An insulating layer IL including an inorganic insulating material and/or an organic insulating material may be disposed between the pixel driving circuit portions PC and the light-emitting elements LED. The light-emitting elements LED may be disposed on the insulating layer IL and electrically connected to the pixel driving circuit portions PC corresponding to the light-emitting elements LED. The light-emitting elements LED may emit light of different colors or emit light of the same color. In an embodiment, the light-emitting elements LED may respectively emit red light, green light, and blue light. In some embodiments, the light-emitting elements LED may emit white light. In another embodiment, the light-emitting elements LED may respectively emit red light, green light, blue light, and white light.

The substrate 100 may include polymer resin such as polyethersulfone, polyarylate, polyetherimide, polyethylene naphthalate, polyethylene terephthalate ("PET"), polyphenylene sulfide, polyimide, polycarbonate, cellulose triacetate, or cellulose acetate propionate, for example. In an embodiment, the substrate 100 may be a single layer including the above-described polymer resin. In another embodiment, the substrate 100 may have a multi-layered structure including a base layer including the aforementioned polymer resin and a barrier layer including an inorganic insulating material. The substrate 100 including polymer resin may be flexible, rollable, or bendable.

In an embodiment, although it is shown in FIG. 5 that three pixel driving circuit portions PC are arranged in the first island portion 11 and three light-emitting elements LED are respectively connected to the three pixel driving circuit portions PC, the disclosure is not limited thereto. In another embodiment, the respective numbers of pixel driving circuit portions PC and light-emitting elements LED disposed in the first island portion 11 may be one, two, four, or more.

An encapsulation layer 300 may be disposed on the light-emitting elements LED and may protect the light-emitting elements LED from an external force and/or moisture transmission. The encapsulation layer 300 may include an organic encapsulation layer and/or an inorganic encapsulation layer. In some embodiments, the encapsulation layer 300 may have a structure in which an inorganic encapsulation layer including an inorganic insulating material, an organic encapsulation layer including an organic insulating material, and an inorganic encapsulation layer including an inorganic insulating material are stacked. In another embodiment, the encapsulation layer 300 may include an organic material such as resin. In some embodiments, the encapsulation layer 300 may include urethane epoxy acrylate. The encapsulation layer 300 may include a photosensitive material, e.g., a photoresist.

Regarding the first bridge portion 12, the insulating layer IL including an organic insulating material may be disposed on the substrate 100. Unlike the first island portion 11, the first bridge portion 12, which is relatively transformed much when the display apparatus 1 is stretched, may not include a layer including an inorganic insulating material that is prone to cracking.

In an embodiment, the substrate 100 corresponding to the first bridge portion 12 may have the same stack structure as the substrate 100 corresponding to the first island portion 11. In an embodiment, the substrate 100 corresponding to the first bridge portion 12 and the substrate 100 corresponding to the first island portion 11 may be polymer resin layers simultaneously formed during the same process. In another embodiment, the substrate 100 corresponding to the first bridge portion 12 may have a different stack structure from the substrate 100 corresponding to the first island portion 11. In some embodiments, the substrate 100 corresponding to the first bridge portion 12 may have a multi-layered structure including a base layer including polymer resin and a barrier layer including an inorganic insulating material, and the substrate 100 corresponding to the first bridge portion 12 may have a structure of a polymer resin layer without a layer including an inorganic insulating material.

As described above, the wirings WL of the first bridge portion 12 may be signal lines (e.g., a gate line and a data line) configured to provide electrical signals to transistors included in the pixel driving circuit portions PC of the first island portion 11, or may be voltage lines (e.g., a driving voltage line and an initialization voltage line) configured to provide voltages. The encapsulation layer 300 may also be disposed in the first bridge portion 12. In another embodiment, the encapsulation layer 300 may not be in the first bridge portion 12.

Referring to FIGS. 4A through 4C and FIG. 5, the substrate 100 corresponding to the first island portion 11 and the substrate 100 corresponding to the first bridge portion 12 may be connected to each other. In other words, the plan views of FIGS. 4A through 4C may be substantially the same as the plan view of the substrate 100 of FIG. 5. In other words, the substrate 100 may include a region corresponding to the first island portion 11, and a region corresponding to the first bridge portion 12, and an opening 100OP1 having a shape equal to the shape of the first opening CS1 may be defined in the substrate 100.

Similarly, the encapsulation layer 300 corresponding to the first island portion 11 and the encapsulation layer 300 corresponding to the first bridge portion 12 may be extended or connected to each other. In an embodiment, the plan views of FIGS. 4A through 4C may be substantially the same as the plan view of the encapsulation layer 300, for example. In other words, the encapsulation layer 300 may include a region corresponding to the first island portion 11, and a region corresponding to the first bridge portion 12, and an opening 300OP1 having a shape equal to the shape of the first opening CS1 may be defined in the encapsulation layer 300.

A circuit-light-emitting element layer 200 between the substrate 100 and the encapsulation layer 300 may include the buffer layer 111, the pixel driving circuit portions PC, the wirings WL, the insulating layer IL, and the light-emitting elements LED. Similar to the substrate 100, the plan views of FIGS. 4A through 4C may be substantially the same as the plan view of the circuit-light-emitting element layer 200. In other words, an opening 200OP1 having the same shape as that of the first opening CS1 may be defined in the circuit-light-emitting element layer 200.

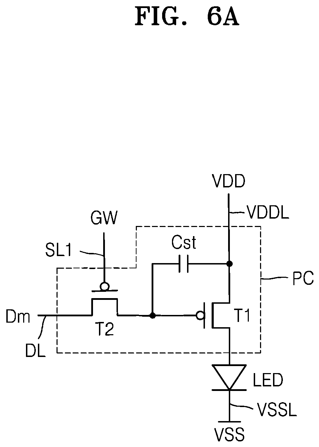

FIGS. 6A through 6C are equivalent circuit diagrams of an embodiment of a sub-pixel of the display apparatus 1.

Referring to FIG. 6A, a light-emitting element LED corresponding to the sub-pixel may be electrically connected to the pixel driving circuit portion PC, and the pixel driving circuit portion PC may include a first transistor T1, a second transistor T2, and a storage capacitor Cst. The pixel driving circuit portion PC may be electrically connected to the signal lines and the voltage lines. The signal lines may include a gate line such as a first scan line SL1, and a data line DL, and the voltage lines may include a first voltage line VDDL.

The second transistor T2 may be electrically connected to the first scan line SL1 and the data line DL. The first scan line SL1 may provide a first scan signal GW to a gate electrode of the second transistor T2. The second transistor T2 may transfer a data signal Dm to the first transistor T1 according to the first scan signal GW input from the first scan line SL1, where the data signal Dm is received from the data line DL.

The storage capacitor Cst may be electrically connected to the second transistor T2 and the first voltage line VDDL, and may store a voltage corresponding to a difference between a voltage received from the second transistor T2 and a first power supply voltage VDD supplied by the first voltage line VDDL.

The first transistor T1, which is a driving transistor, may control a driving current flowing through the light-emitting element LED. The first transistor T1 may be connected to the first voltage line VDDL and the storage capacitor Cst. The first transistor T1 may control a driving current flowing from the first voltage line VDDL to the light-emitting element LED according to a voltage value stored in the storage capacitor Cst. The light-emitting element LED may emit light having a predetermined brightness according to the driving current. A first electrode of the light-emitting element LED may be electrically connected to the first transistor T1, and a second electrode of the light-emitting element LED may be electrically connected to a second voltage line VSSL configured to supply a second power voltage VSS.

In FIG. 6A, the pixel driving circuit portion PC includes two transistors and one storage capacitor. However, in another embodiment, the pixel driving circuit portion PC may include three or more transistors.

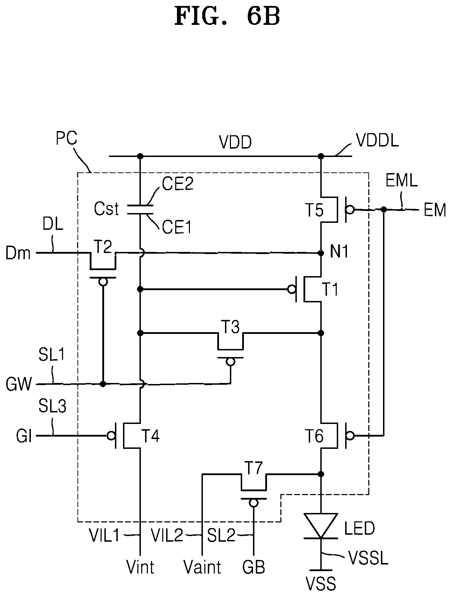

Referring to FIG. 6B, the pixel driving circuit portion PC may include a first transistor T1, a second transistor T2, a third transistor T3, a fourth transistor T4, a fifth transistor T5, a sixth transistor T6, a seventh transistor T7, and a storage capacitor Cst.

The pixel driving circuit portion PC is electrically connected to the signal lines and the voltage lines. The signal lines may include gate lines, such as a first scan line SL1, a second scan line SL2, a third scan line SL3, and a light-emission control line EML, and a data line DL. The voltage lines may include first and second initializing voltage lines VIL1 and VIL2 and the first voltage line VDDL.

The first voltage line VDDL may transmit the first power supply voltage VDD to the first transistor T1. The first initializing voltage line VIL1 may transmit, to the pixel driving circuit portion PC, a first initializing voltage Vint that initializes the first transistor T1. The second initializing voltage line VIL2 may transmit, to the pixel driving circuit portion PC, a second initializing voltage Vaint that initializes a first electrode of the light-emitting element LED.

The first transistor T1 may be electrically connected to the first voltage line VDDL through the fifth transistor T5, and may be electrically connected to the light-emitting element (e.g., light-emitting diode) LED through the sixth transistor T6. The first transistor T1 severs as a driving transistor, and receives a data signal Dm according to a switching operation of the second transistor T2 and supplies a driving current to the light-emitting element LED.

The second transistor T2, which is a data write transistor, is electrically connected to the first scan line SL1 and the data line DL. The second transistor T2 is electrically connected to the first voltage line VDDL through the fifth transistor T5. The second transistor T2 is turned on in response to a first scan signal GW received through the first scan line SL1, to perform a switching operation of transmitting the data signal Dm received through the data line DL to a first node N1.

The third transistor T3 is electrically connected to the first scan line SL1, and is electrically connected to the light-emitting element LED via the sixth transistor T6. The third transistor T3 may be turned on according to the first scan signal GW received via the first scan line SL1 and diode-connect the first transistor T1.

The fourth transistor T4, which is a first initialization transistor, is electrically connected to the third scan line SL3 and the first initializing voltage line VIL1. The fourth transistor T4 is turned on in response to a third scan signal GI received through the third scan line SL3, and transmit the first initializing voltage Vint from the first initializing voltage line VIL1 to the gate electrode of the first transistor T1 to thereby initialize the voltage of the gate electrode of the first transistor T1. The third scan signal GI may correspond to a first scan signal of another pixel driving circuit portion disposed in a row previous to the row of the current pixel driving circuit portion PC.

The fifth transistor T5 may be an operation control transistor, and the sixth transistor T6 may be a light-emission control transistor. The fifth transistor T5 and the sixth transistor T6 are electrically connected to the light-emission control line EML, and are simultaneously turned on according to a light-emission control signal EM received through the light-emission control line EML and form a current path so that the driving current flows from the first voltage line VDDL toward the light-emitting element LED.

The seventh transistor T7, which is a second initialization transistor, may be electrically connected to the second scan line SL2, the second initializing voltage line VIL2, and the sixth transistor T6. The seventh transistor T7 may be turned on according to a second scan signal GB received through the second scan line SL2, and may transfer the second initializing voltage Vaint from the second initializing voltage line VIL2 to the first electrode of the light-emitting element LED to thereby initialize the first electrode of the light-emitting element LED.

The storage capacitor Cst includes a first electrode CE1 and a second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1, by storing and maintaining a voltage corresponding to a difference between the voltage of the first voltage line VDDL and the voltage of the gate electrode of the first transistor T1.

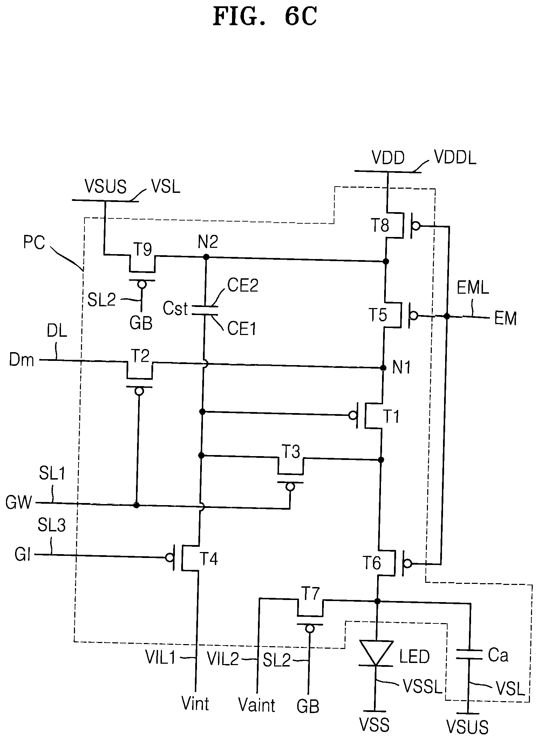

Referring to FIG. 6C, the pixel driving circuit portion PC may include a first transistor T1, a second transistor T2, a third transistor T3, a fourth transistor T4, a fifth transistor T5, a sixth transistor T6, a seventh transistor T7, an eighth transistor T8, a ninth transistor T9, a storage capacitor Cst, and an auxiliary capacitor Ca.

The pixel driving circuit portion PC is electrically connected to the signal lines and the voltage lines. The signal lines may include gate lines, such as a first scan line SL1, a second scan line SL2, a third scan line SL3, and a light-emission control line EML, and a data line DL. The voltage lines may include first and second initializing voltage lines VIL1 and VIL2, a sustain voltage line VSL, and the first voltage line VDDL.

The first voltage line VDDL may transmit the first power supply voltage VDD to the first transistor T1. The first initializing voltage line VIL1 may transmit, to the pixel driving circuit portion PC, a first initializing voltage Vint that initializes the first transistor T1. The second initializing voltage line VIL2 may transmit, to the pixel driving circuit portion PC, a second initializing voltage Vaint that initializes a first electrode of the light-emitting element LED. The sustain voltage line VSL may provide a sustain voltage VSUS to a second node N2, e.g., the second electrode CE2 of the storage capacitor Cst, during an initialization section and a data-write section.

The first transistor T1 may be electrically connected to the first voltage line VDDL through the fifth transistor T5 and the eighth transistor T8, and may be electrically connected to the light-emitting element (e.g., light-emitting diode) LED through the sixth transistor T6. The first transistor T1 severs as a driving transistor, and may receive a data signal Dm according to a switching operation of the second transistor T2 and supply a driving current to the light-emitting element LED.

The second transistor T2 is electrically connected to the first scan line SL1 and the data line DL, and is electrically connected to the first voltage line VDDL via the fifth transistor T5 and the eighth transistor T8. The second transistor T2 is turned on in response to a first scan signal GW received through the first scan line SL1, to perform a switching operation of transmitting the data signal Dm received through the data line DL to a first node N1.

The third transistor T3 is electrically connected to the first scan line SL1, and is electrically connected to the light-emitting element LED via the sixth transistor T6. The third transistor T3 may be turned on in response to the first scan signal GW received through the first scan line SL1 to diode-connect the first transistor T1, thereby compensating for a threshold voltage of the first transistor T1.

The fourth transistor T4 is electrically connected to the third scan line SL3 and the first initializing voltage line VIL1, and is turned on according to a third scan signal GI received via the third scan line SL3 and transmit the first initializing voltage Vint from the first initializing voltage line VIL1 to the gate electrode of the first transistor T1 to thereby initialize the voltage of the gate electrode of the first transistor T1. The third scan signal GI may correspond to a first scan signal of another pixel driving circuit portion disposed in a row previous to the row of the current pixel driving circuit portion PC.

The fifth transistor T5, the sixth transistor T6, and the eighth transistor T8 are electrically connected to the light-emission control line EML, and are simultaneously turned on according to a light-emission control signal EM received through the light-emission control line EML and form a current path so that the driving current flows from the first voltage line VDDL toward the light-emitting element LED.

The seventh transistor T7, which is a second initialization transistor, may be electrically connected to the second scan line SL2, the second initializing voltage line VIL2, and the sixth transistor T6. The seventh transistor T7 is turned on according to a second scan signal GB received through the second scan line SL2, and transfers the second initializing voltage Vaint from the second initializing voltage line VIL2 to the first electrode of the light-emitting element LED to thereby initialize the first electrode of the light-emitting element LED.

The ninth transistor T9 may be electrically connected to the second scan line SL2, the second electrode CE2 of the storage capacitor Cst, and the sustain voltage line VSL. The ninth transistor T9 may be turned on according to the second scan signal GB transferred through the second scan line SL2, and may transfer the sustain voltage VSUS to the second node N2, e.g., the second electrode CE2 of the storage capacitor Cst, during the initialization section and the data-write section.

Each of the eighth transistor T8 and the ninth transistor T9 may be electrically connected to the second node N2, e.g., the second electrode CE2 of the storage capacitor Cst. In some embodiments, during the initialization section and the data-write section, the eighth transistor T8 may be turned off and the ninth transistor T9 may be turned on, and, during an emission section, the eighth transistor T8 may be turned on and the ninth transistor T9 may be turned off. Because, during the initialization section and the data-write section, the sustain voltage VSUS is transferred to the second node N2, uniformity in brightness of the display apparatus (e.g., long range uniformity ("LRU")) according to a voltage drop of the first voltage line VDDL may be improved.

The storage capacitor Cst includes a first electrode CE1 and a second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustain voltage line VSL, and the first electrode of the light-emitting element LED. While the seventh transistor T7 and the ninth transistor T9 are being turned on, the auxiliary capacitor Ca stores and maintains a voltage corresponding to a difference between the voltage of the first electrode of the light-emitting element LED and the voltage of the sustain voltage line VSL, thereby preventing a black brightness from rising when the sixth transistor T6 is turned off.

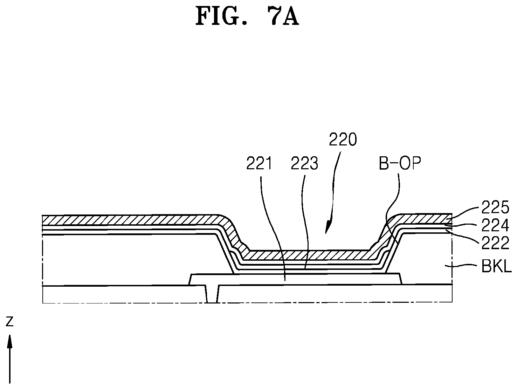

FIG. 7A is a schematic cross-sectional view of an embodiment of a light-emitting element of the display apparatus 1.

Referring to FIG. 7A, the light-emitting element in an embodiment may include an organic light-emitting diode 220 including an organic material. The organic light-emitting diode 220 may include a first electrode 221 disposed on an insulating layer, a second electrode 225 facing the first electrode 221, and an emission layer 223 interposed between the first electrode 221 and the second electrode 225. A first functional layer 222 may be interposed between the first electrode 221 and the emission layer 223, and a second functional layer 224 may be interposed between the emission layer 223 and the second electrode 225.

An edge of the first electrode 221 may be covered with a bank layer BKL including an insulating material. An opening B-OP overlapping a center portion of the first electrode 221 may be defined in the bank layer BKL.

The first electrode 221 may include conductive oxide such as indium tin oxide ("ITO"), indium zinc oxide ("IZO"), zinc oxide (ZnO), indium oxide (In₂O₃), indium gallium oxide ("IGO"), or aluminum zinc oxide ("AZO"). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound of these materials. In another embodiment, the first electrode 221 may further include a layer including or including ITO, IZO, ZnO, or In₂O₃ over/under the reflective layer.

The emission layer 223 may include a relatively low molecular or relatively high molecular organic material that emits light of a predetermined color. The first functional layer 222 may include a hole transport layer ("HTL") and/or a hole injection layer ("HIL"). The second functional layer 224 may include an electron transport layer ("ETL") and/or an electron injection layer ("EIL").

The second electrode 225 may include a conductive material having a relatively low work function. In an embodiment, the second electrode 225 may include a (semi)transparent layer including, e.g., silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca) or an alloy of these materials. In an alternative embodiment, the second electrode 225 may further include a layer, such as ITO, IZO, ZnO, AZO, or In₂O₃, on the (semi)transparent layer including any of the above-described materials.

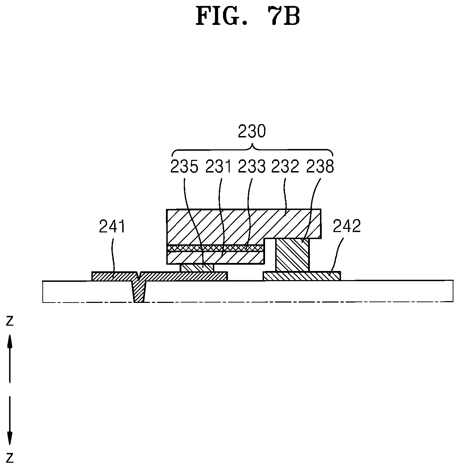

FIG. 7B is a schematic cross-sectional view of an embodiment of a light-emitting element of the display apparatus 1.

Referring to FIG. 7B, the light-emitting element in an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and the second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be electrically connected to a first electrode pad 241 and a second electrode pad 242, respectively, disposed in the same layer.

In some embodiments, the first semiconductor layer 231 may include a p-type semiconductor layer. The p-type semiconductor layer may be selected from semiconductor materials having a composition formula of InₓAl_{y}Ga_{1-x-y}N (0≥x≥1, 0≥y≥1, 0≥x+y≥1), e.g., GaN, AIN, AlGaN, InGaN, InN, InAlGaN, and AlInN, and may be doped with a p-type dopant such as Mg, Zn, Ca, Sr, or Ba.

The second semiconductor layer 232 may include, e.g., an n-type semiconductor layer. The n-type semiconductor layer may be selected from semiconductor materials having a composition formula of InxAlyGa1-x-yN (0≥x≥1, 0≥y≥1, 0≥x+y≥1), e.g., GaN, AIN, AlGaN, InGaN, InN, InAlGaN, and AlInN, and may be doped with an n-type dopant such as Si, Ge, or Sn.

The intermediate layer 233, in which electrons and holes are recombined, may transit to a relatively low energy level due to recombination between electrons and holes, and accordingly, may generate light having a wavelength corresponding to the relatively low energy level. The intermediate layer 233 may be formed by including a semiconductor material having a composition formula of InₓAl_{y}Ga_{1-x-y}N (0≥x≥1, 0≥y≥1, 0≥x+y≥1), and may have a single quantum well structure or a multi-quantum well ("MQW") structure. In an alternative embodiment, the intermediate layer 233 may have a quantum wire structure or a quantum dot structure.

It has been described with reference to FIG. 7B that the first semiconductor layer 231 includes a p-type semiconductor layer and the second semiconductor layer 232 includes an n-type semiconductor layer, but the disclosure is not limited thereto. In another embodiment, the first semiconductor layer 231 may include an n-type semiconductor layer, and the second semiconductor layer 232 may include a p-type semiconductor layer.

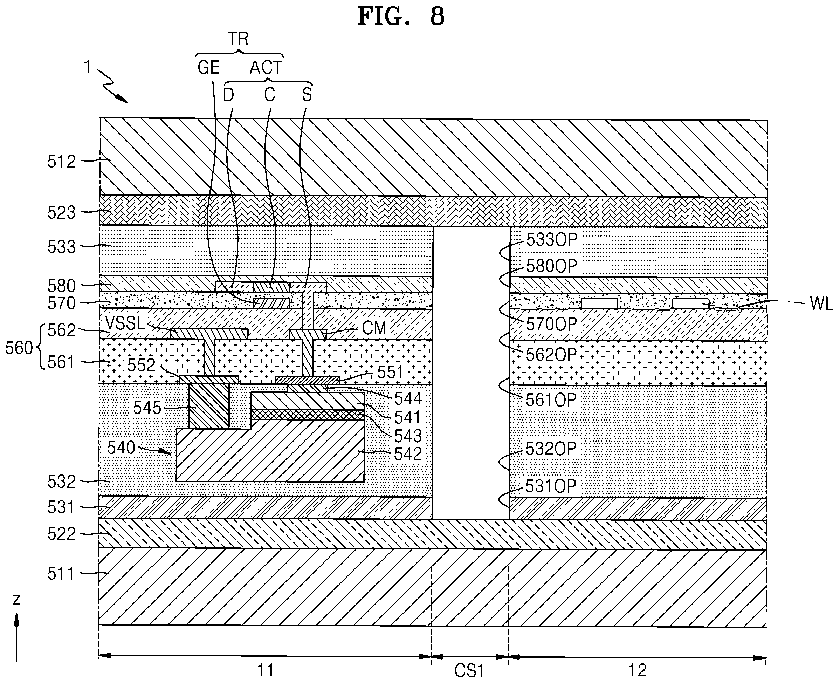

FIG. 8 is a schematic cross-sectional view of an embodiment of a portion of the display apparatus 1.

Reference numerals in FIG. 8 that are the same as those in FIGS. 1 through 7B denote the same elements, and thus repeated descriptions thereof are omitted.

Referring to FIG. 8, the display apparatus 1 may include a first encapsulation layer 511, a first adhesive layer 522, a first substrate 531, a second substrate 532, a light-emitting diode 540, a first electrode pad 551, a second electrode pad 552, a planarization insulating layer 560, a connection electrode CM, a second voltage line VSSL, a gate insulating layer 570, a buffer layer 580, transistor TR, a wiring WL, a third substrate 533, a second adhesive layer 523, and a second encapsulation layer 512.

The first encapsulation layer 511 may be disposed below the first substrate 531 to support the first substrate 531. The first encapsulation layer 511 may include or consist of an elongated sheet. The first encapsulation layer 511 may be provided as an elastomer film, a polydimethylsiloxane ("PDMS") film, a silicon film, etc.

The first adhesive layer 522 may be disposed on the first encapsulation layer 511. The first adhesive layer 522 may be in direct contact with an upper surface of the first encapsulation layer 511 and a lower surface of the first substrate 531. The first adhesive layer 522 may attach the first encapsulation layer 511 to the first substrate 531. The first adhesive layer 522 may be a pressure sensitive adhesive ("PSA"), an optically clear adhesive ("OCA"), or the like. The first adhesive layer 522 may include an acryl-based, silicon-based, or urethane-based material.

The first substrate 531 is able to elongate and may be disposed on the first encapsulation layer 511. The first adhesive layer 522 may be interposed between the first substrate 531 and the first encapsulation layer 511. An opening 531OP having the same shape as that of the first opening CS1 may be defined in the first substrate 531. The first substrate 531 may include a transparent material.

The first substrate 531 may include polymer resin such as polyethersulfone, polyarylate, polyetherimide, polyethylene naphthalate, PET, polyphenylene sulfide, polyimide, polycarbonate, cellulose triacetate, or cellulose acetate propionate, for example.

The second substrate 532 is able to elongate and may be disposed on the first substrate 531. An opening 532OP having the same shape as that of the first opening CS1 may be defined in the second substrate 532. The first substrate 531 and the second substrate 532 may include different materials from each other. In an embodiment, light transmittance of the first substrate 531 may be different from light transmittance of the second substrate 532, for example. In an embodiment, the first substrate 531 may include a transparent material, and the second substrate 532 may include an opaque material, for example. However, this is an illustrative embodiment, and the first substrate 531 and the second substrate 532 may include the same material as each other.

The second substrate 532 may include polymer resin such as polyethersulfone, polyarylate, polyetherimide, polyethylene naphthalate, PET, polyphenylene sulfide, polyimide, polycarbonate, cellulose triacetate, or cellulose acetate propionate, for example.

At least a portion of the light-emitting diode 540 may be accommodated in the second substrate 532. The light-emitting diode 540 may be disposed inside the second substrate 532, within the first island portion 11. The light-emitting diode 540 may include a first semiconductor layer 541, a second semiconductor layer 542, an intermediate layer 543, a first electrode 544, and a second electrode 545.

The light-emitting diode 540 may correspond to the inorganic light-emitting diode 230 described above with reference to FIG. 7B. In detail, the first semiconductor layer 541, the second semiconductor layer 542, the intermediate layer 543, the first electrode 544, and the second electrode 545 may correspond to the first semiconductor layer 231, the second semiconductor layer 232, the intermediate layer 233, the first electrode 235, and the second electrode 238 described above with reference to FIG. 7B, respectively.

The second semiconductor layer 542 may be disposed below the first semiconductor layer 541. The intermediate layer 543 may be disposed between the first semiconductor layer 541 and the second semiconductor layer 542. The first electrode 544 may be disposed on the first semiconductor layer 541. The second electrode 545 may be disposed on the second semiconductor layer 542 to be spaced apart from the first semiconductor layer 541. Portions of the first electrode 544 and the second electrode 545 may be exposed through the second substrate 532. In an embodiment, respective upper surfaces of the first electrode 544 and the second electrode 545 may form the same plane as the upper surface of the second substrate 532, for example.

The light-emitting diode 540 may be spaced apart from the first substrate 531. In this case, each of the first substrate 531 and the second substrate 532 may include a transparent material. Light emitted from the light-emitting diode 540 may sequentially pass through the second substrate 532, the first substrate 531, the first adhesive layer 522, and the first encapsulation layer 511 and may be displayed on the outside.

The first electrode pad 551 may be disposed on the second substrate 532 to be electrically connected to the light-emitting diode 540. The first electrode pad 551 may contact the first electrode 544 and electrically connected to the first electrode 544. The second electrode pad 552 may be disposed on the second substrate 532 to be electrically connected to the light-emitting diode 540. The second electrode pad 552 may contact the second electrode 545 and electrically connected to the second electrode 545. The first electrode pad 551 and the second electrode pad 552 may each be disposed in the first island portion 11.

The first electrode pad 551 may correspond to the first electrode pad 241 described above with reference to FIG. 7B. The second electrode pad 552 may correspond to the second electrode pad 242 described above with reference to FIG. 7B.

The planarization insulating layer 560 may be disposed on the second substrate 532 to cover the first electrode pad 551 and the second electrode pad 552. The planarization insulating layer 560 may include an organic insulating material, such as a commercial polymer (such as, polymethylmethacrylate ("PMMA")or polystyrene ("PS")), a polymer derivative having a phenol-based group, an acrylic polymer, an imide-based polymer, an acryl ether-based polymer, an amide-based polymer, a fluorine-based polymer, a p-xylene-based polymer, a vinyl alcohol-based polymer, or any combinations thereof.

The planarization insulating layer 560 may include a first planarization insulating layer 561 and a second planarization insulating layer 562. The second planarization insulating layer 562 may be disposed on the first planarization insulating layer 561. In an embodiment, the first planarization insulating layer 561 and the second planarization insulating layer 562 may include the same materials, for example. However, this is an illustrative embodiment, and the first planarization insulating layer 561 and the second planarization insulating layer 562 may include different materials from each other.

Openings 561OP and 562OP each having the same shape as that of the first opening CS1 may be defined in the planarization insulating layer 560. In other words, the opening 561OP having the same shape as that of the first opening CS1 may be defined in the first planarization insulating layer 561. The opening 562OP having the same shape as that of the first opening CS1 may be defined in the second planarization insulating layer 562.

The connection electrode CM and the second voltage line VSSL may be disposed between the first planarization insulating layer 561 and the second planarization insulating layer 562. The connection electrode CM and the second voltage line VSSL may each be disposed on the first planarization insulating layer 561. The second planarization insulating layer 562 may cover the connection electrode CM and the second voltage line VSSL. The connection electrode CM and the second voltage line VSSL may be spaced apart from each other. The connection electrode CM and the second voltage line VSSL may each be electrically connected to the light-emitting diode 540. The connection electrode CM may pass through the first planarization insulating layer 561 and contact the first electrode pad 551. The second voltage line VSSL may pass through the first planarization insulating layer 561 and contact the second electrode pad 552. The second voltage line VSSL may correspond to the second voltage line VSSL described above with reference to FIGS. 6A through 6C.

The gate insulating layer 570 may be disposed on the planarization insulating layer 560. The gate insulating layer 570 may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOx). The zinc oxide (ZnOₓ) may be a zinc oxide (ZnO) and/or a zinc peroxide (ZnO₂). An opening 570OP having the same shape as that of the first opening CS1 may be defined in the gate insulating layer 570.

The buffer layer 580 may be disposed on the gate insulating layer 570. The buffer layer 580 may include an inorganic insulating material, such as silicon oxide, silicon oxynitride, or silicon nitride, and may be a single layer or multiple layers including the inorganic insulating material. An opening 580OP having the same shape as that of the first opening CS1 may be defined in the buffer layer 580.

The transistor TR may be disposed on the planarization insulating layer 560 and may be electrically connected to the first electrode pad 551. The transistor TR may be disposed in the first island portion 11. The transistor TR may include an active layer ACT and a gate electrode GE.

The active layer ACT may be between the gate insulating layer 570 and the buffer layer 580. The active layer ACT may be disposed on the gate insulating layer 570, and the buffer layer 580 may cover the active layer ACT. The active layer ACT may include polysilicon. In an alternative embodiment, the active layer ACT may include amorphous silicon, an oxide semiconductor, an organic semiconductor, or the like. The active layer ACT may include a channel region C and a drain region D and a source region S respectively arranged on opposite sides of the channel region C. In this case, the connection electrode CM may electrically connect the source region S to the first electrode pad 551.

The gate electrode GE may be disposed between the planarization insulating layer 560 and the gate insulating layer 570. The gate electrode GE may be disposed on the planarization insulating layer 560, and the gate insulating layer 570 may cover the gate electrode GE. In other words, the transistor TR may be provided as a top gate type in which the gate electrode GE is disposed between the light-emitting diode 540 and the active layer ACT. The gate electrode GE may overlap the channel region C. The gate electrode GE may include a relatively low resistance metal material. The gate electrode GE may include a conductive material including molybdenum (Mo), aluminum (Al), copper (Cu), and titanium (Ti), and may be formed as a multi-layer or single layer including the aforementioned materials.

The wiring WL may be disposed in the first bridge portion 12. The wiring WL may correspond to the wiring WL described above with reference to FIG. 5. FIG. 8 shows two wirings WL disposed on the planarization insulating layer 560 and the gate insulating layer 570. However, this is only an example, and the number of wirings WL and the arrangement of the wirings WL are not limited thereto.

The third substrate 533 is able to elongate and may be disposed on the buffer layer 580. In other words, the third substrate 533 may be disposed on the transistor TR. An opening 533OP having the same shape as that of the first opening CS1 may be defined in the third substrate 533. The third substrate 533 may include polymer resin such as polyethersulfone, polyarylate, polyetherimide, polyethylene naphthalate, PET, polyphenylene sulfide, polyimide, polycarbonate, cellulose triacetate, or cellulose acetate propionate, for example.

The second adhesive layer 523 may be disposed on the third substrate 533. The second adhesive layer 523 may be in direct contact with an upper surface of the third substrate 533 and a lower surface of the second encapsulation layer 512. The second adhesive layer 523 may attach the third substrate 533 to the second encapsulation layer 512. The second adhesive layer 523 may be a PSA, an OCA, or the like. The second adhesive layer 523 may include an acryl-based, silicon-based, or urethane-based material.

The second encapsulation layer 512 may be disposed on the third substrate 533. The second encapsulation layer 512 may support the third substrate 533. The second encapsulation layer 512 may include or consist of an elongated sheet. The second encapsulation layer 512 may be provided as an elastomer film, a PDMS film, a silicon film, etc.

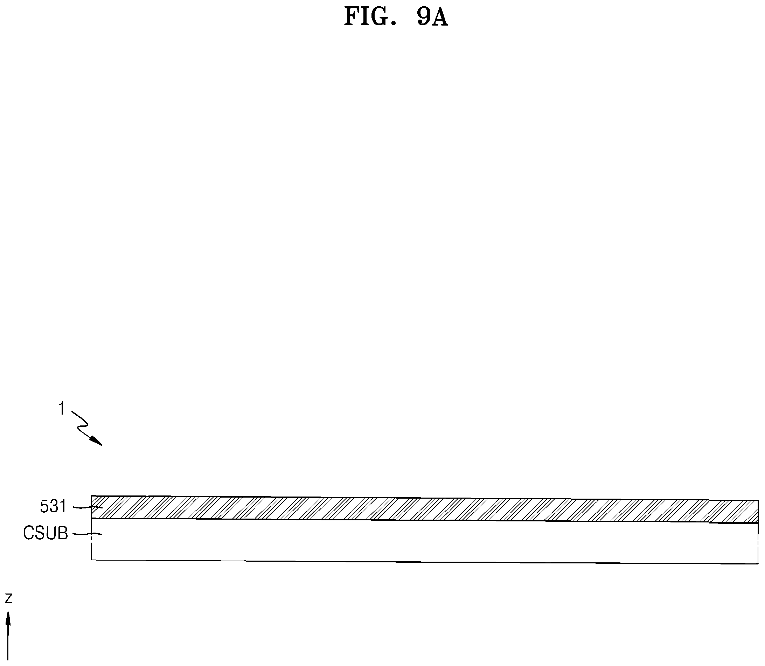

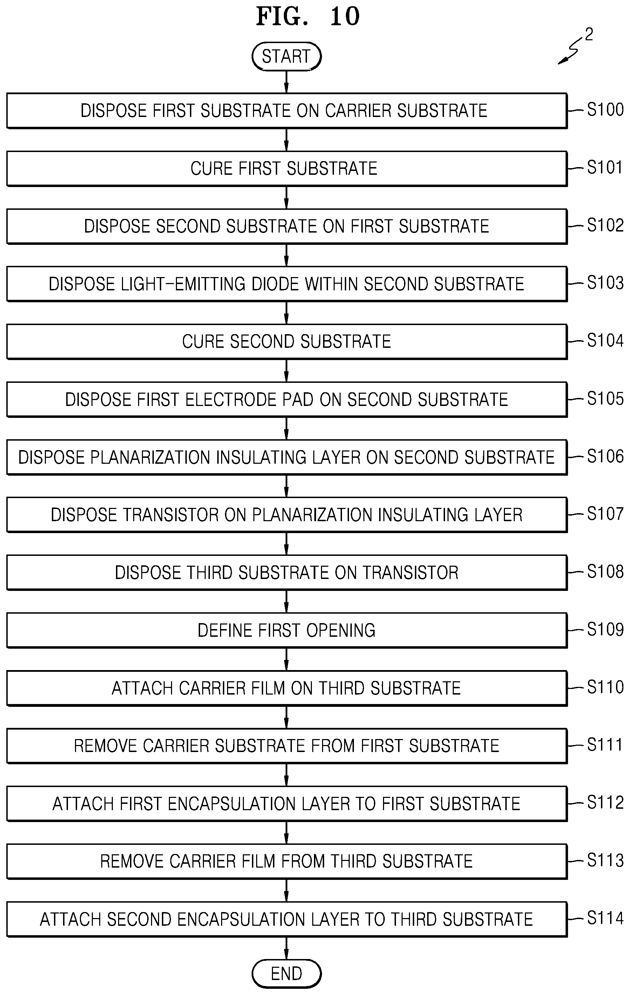

FIGS. 9A through 9H are schematic cross-sectional views of an embodiment of a portion of the display apparatus 1 in an embodiment, and FIG. 10 is a schematic flowchart of an embodiment of a method 2 of manufacturing a display apparatus.

Referring to FIGS. 9A through 10, a method of manufacturing the display apparatus 1 described above with reference to FIG. 8 may be seen.

Reference numerals in FIGS. 9A through 10 that are the same as the reference numerals in FIG. 8 denote the same elements, and thus repeated descriptions thereof are omitted.

First, referring to FIGS. 9A and 10, the method 2 of manufacturing a display apparatus may include operation S100 of disposing a first substrate 531 on a carrier substrate CSUB, and operation S101 of curing the first substrate 531.

The carrier substrate CSUB is a substrate that supports the first substrate 531 during a process, and may include a glass material. After the first substrate 531 is disposed on the carrier substrate CSUB, the first substrate 531 may be cured. The first substrate 531 may cover the carrier substrate CSUB.

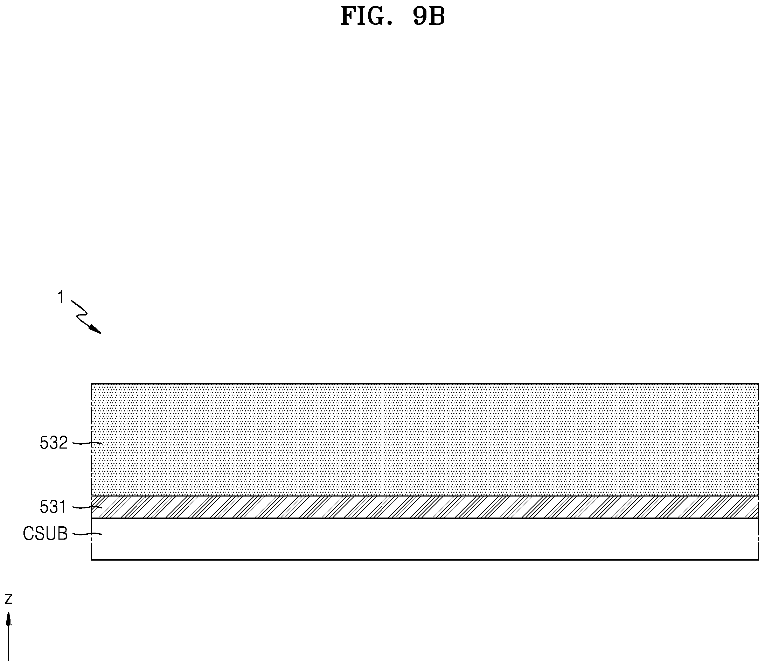

Referring to FIGS. 9B and 10, the method 2 of manufacturing a display apparatus may include operation S102 of disposing the second substrate 532 on the first substrate 531. The second substrate 532 may be disposed on the first substrate 531 and cover the first substrate 531.

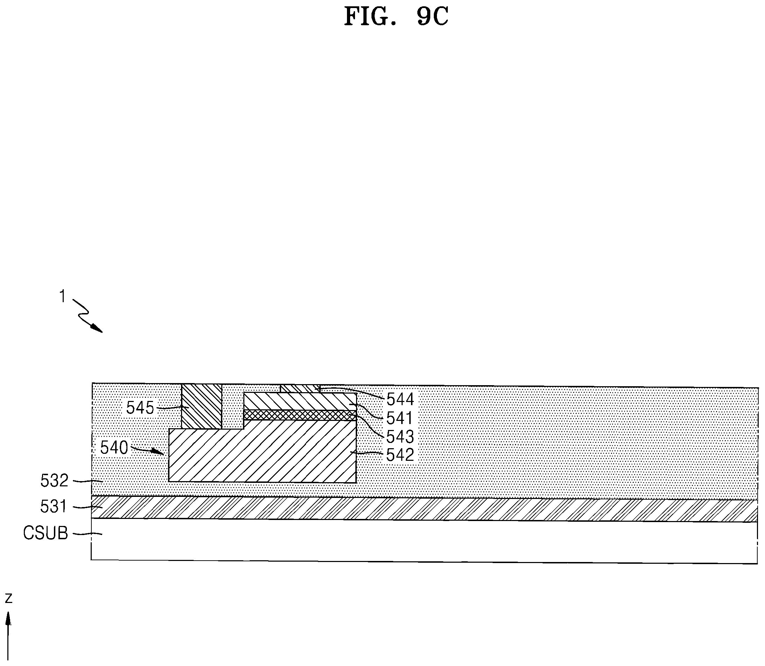

Referring to FIGS. 9C and 10, the method 2 of manufacturing a display apparatus may include operation S103 of disposing the light-emitting diode 540 within the second substrate 532, and operation S104 of curing the second substrate 532.

Before the second substrate 532 is cured, at least a portion of the light-emitting diode 540 may be accommodated in the second substrate 532. The light-emitting diode 540 may include the first semiconductor layer 541, the second semiconductor layer 542, the intermediate layer 543, the first electrode 544, and the second electrode 545. When the light-emitting diode 540 is disposed inside the second substrate 532, the second substrate 532 may be cured.

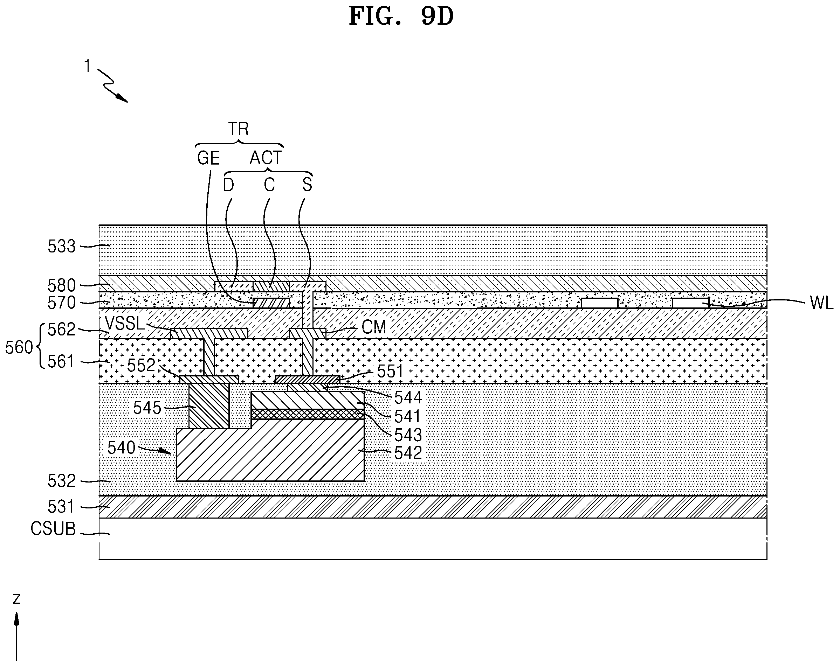

Referring to FIGS. 9D and 10, the method 2 of manufacturing a display apparatus may include operation S105 of disposing the first electrode pad 551 on the second substrate 532, operation S106 of disposing the planarization insulating layer 560 on the second substrate 532, operation S107 of disposing the transistor TR on the planarization insulating layer 560, and operation S108 of disposing the third substrate 533 on the transistor TR. In operation S105 of disposing the first electrode pad 551 on the second substrate 532, the second electrode pad 552 may be disposed on the second substrate 532.

While the first electrode pad 551 is being disposed on the second substrate 532, a separate bonding process for bonding the first electrode pad 551 to the light-emitting diode 540 may not be desired. In an embodiment, a flux coating or resin coating process for removing oxide on a surface where the first electrode pad 551 and the second substrate 532 contact each other may not be desired, for example.

Likewise, while the second electrode pad 552 is being disposed on the second substrate 532, a separate bonding process for bonding the second electrode pad 552 to the light-emitting diode 540 may not be desired. In an embodiment, a flux coating or resin coating process for removing oxide on a surface where the second electrode pad 552 and the second substrate 532 contact each other may not be desired, for example. In other words, a process for manufacturing the display apparatus 1 may be simplified.

Operation S106 of disposing the planarization insulating layer 560 on the second substrate 532 may include disposing the first planarization insulating layer 561 on the second substrate 532, and disposing the second planarization insulating layer 562 on the first planarization insulating layer 561. In this case, the connection electrode CM and the second voltage line VSSL may be interposed between the first planarization insulating layer 561 and the second planarization insulating layer 562.

The gate insulating layer 570 and the buffer layer 580 may be disposed between the planarization insulating layer 560 and the third substrate 533. In other words, the gate insulating layer 570 may be disposed on the planarization insulating layer 560, the buffer layer 580 may be disposed on the gate insulating layer 570, and the third substrate 533 may be disposed on the buffer layer 580.

The disposing of the transistor TR may include disposing the gate electrode GE and disposing the active layer ACT. The gate electrode GE may be disposed on the planarization insulating layer 560. The active layer ACT may be disposed on the gate insulating layer 570. In other words, the gate electrode GE may be disposed, the gate insulating layer 570 may be disposed on the gate electrode GE, and the active layer ACT may be disposed on the gate insulating layer 570. The active layer ACT may include the channel region C, the drain region D, and the source region S.

In the above-described process, the method 2 of manufacturing a display apparatus may include disposing the wirings WL. FIG. 9D shows that two wirings WL are disposed on the planarization insulating layer 560 and the gate insulating layer 570. However, this is only an example, and the number of wirings WL and the arrangement of the wirings WL are not limited thereto.

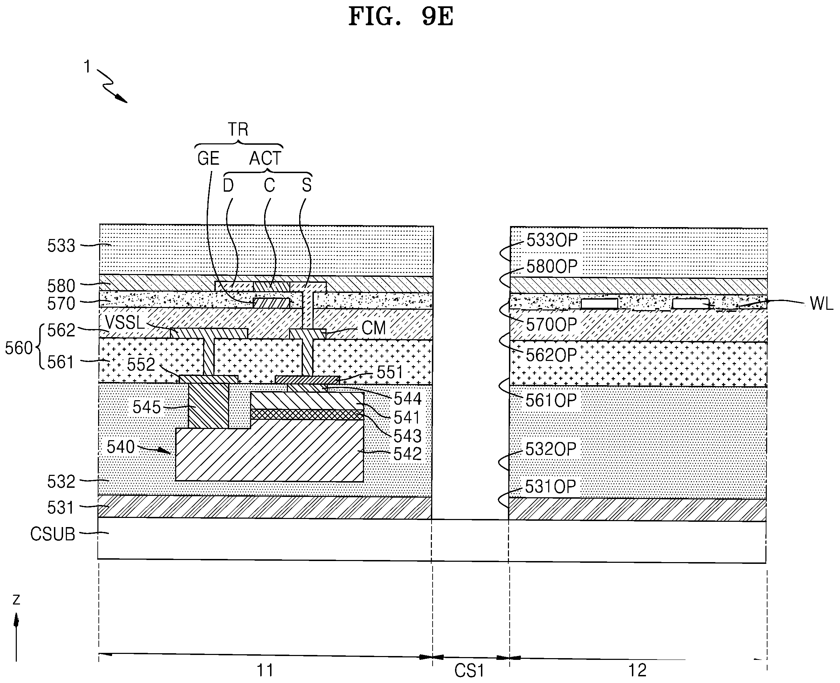

Referring to FIGS. 9E and 10, the method 2 of manufacturing a display apparatus may include operation S109 of defining the first opening CS1. The first opening CS1 may penetrate through the first substrate 531, the second substrate 532, the planarization insulating layer 560, the gate insulating layer 570, the buffer layer 580, and the third substrate 533. The first opening CS1 may contact the first island portion 11 and the first bridge portion 12.

In this process, the opening 531OP may be defined in the first substrate 531, the opening 532OP may be defined in the second substrate 532, the openings 561OP and 562OP may be defined in the planarization insulating layer 560, the opening 570OP may be defined in the gate insulating layer 570, the opening 580OP may be defined in the buffer layer 580, and the opening 533OP may be defined in the third substrate 533. The first opening CS1 may be defined through a photolithography process. In an embodiment, the first opening CS1 may be defined through a process of dry-etching or wet-etching the first substrate 531, the second substrate 532, the planarization insulating layer 560, the gate insulating layer 570, the buffer layer 580, and the third substrate 533, for example.

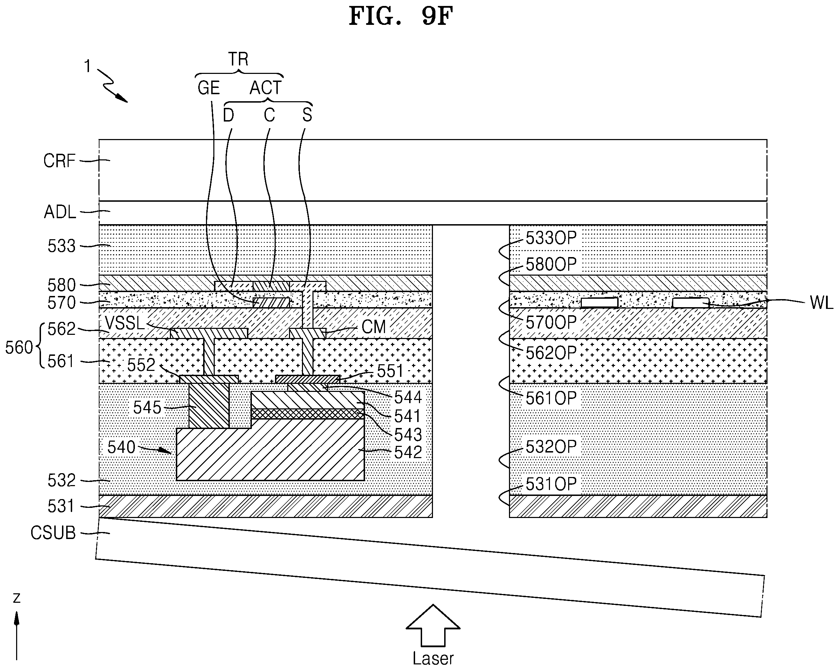

Referring to FIGS. 9F and 10, the method 2 of manufacturing a display apparatus may include operation S110 of attaching a carrier film CRF on the third substrate 533, and operation S111 of removing the carrier substrate CSUB from the first substrate 531.

The carrier film CRF may be attached to the third substrate 533 by a carrier adhesive layer ADL. In other words, the carrier adhesive layer ADL may be disposed on the third substrate 533, and the carrier film CRF may be disposed on the carrier adhesive layer ADL. The carrier film CRF, which is a protective film that facilitates handling during a subsequent process, may include a flexible plastic material such as PET and/or polyimide. The carrier adhesive layer ADL may be a PSA, an OCA, or the like.

The carrier substrate CSUB may be separated from the first substrate 531 by a laser lift off method of radiating a laser beam to a lower portion of the carrier substrate CSUB. In an alternative embodiment, the carrier substrate CSUB may be separated from the first substrate 531 by a known physical or chemical method.

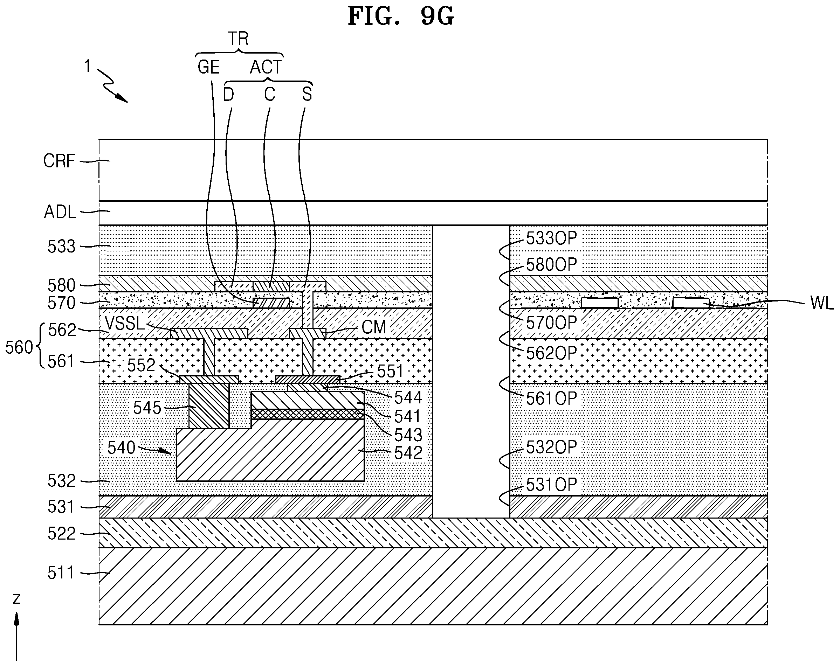

Referring to FIGS. 9G and 10, the method 2 of manufacturing a display apparatus may include operation S112 of attaching the first encapsulation layer 511 to the first substrate 531. The first encapsulation layer 511 may be attached to the first substrate 531 by the first adhesive layer 522. In other words, the first adhesive layer 522 may be disposed on the first encapsulation layer 511, and the first substrate 531 may be disposed on the first adhesive layer 522.

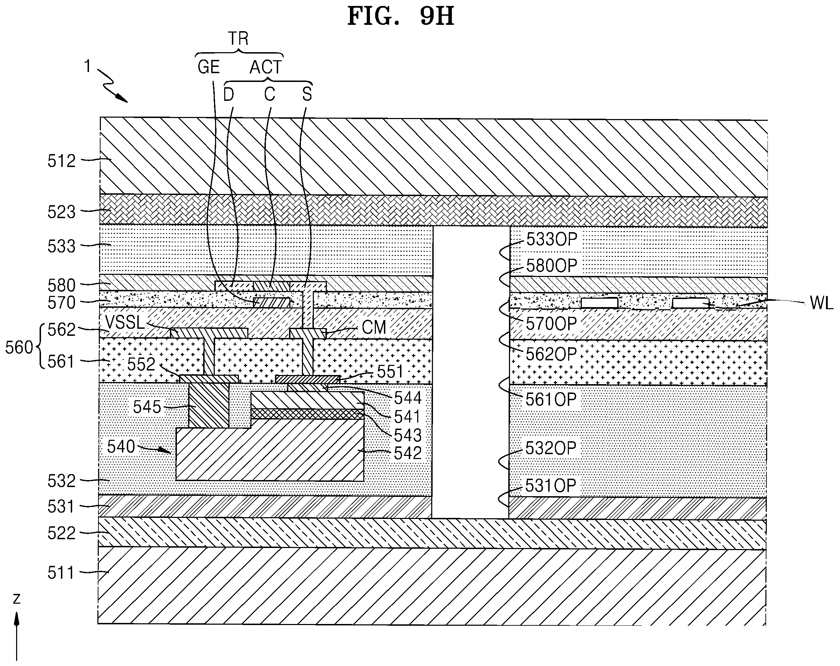

Referring to FIGS. 9G, 9H, and 10, the method 2 of manufacturing a display apparatus may include operation S113 of removing the carrier film CRF from the third substrate 533, and operation S114 of attaching the second encapsulation layer 512 to the third substrate 533. After removing the carrier film CRF and the carrier adhesive layer ADL are removed from the third substrate 533, the second encapsulation layer 512 may be attached to the third substrate 533 by the second adhesive layer 523. In other words, the second adhesive layer 523 may be disposed on the third substrate 533, and the second encapsulation layer 512 may be disposed on the second adhesive layer 523.

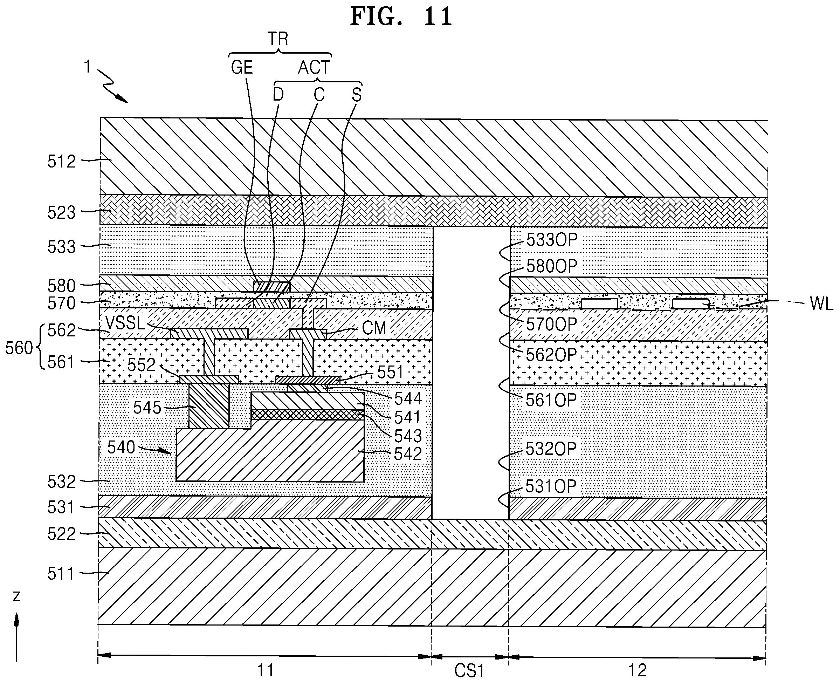

FIG. 11 is a schematic cross-sectional view of an embodiment of a portion of the display apparatus 1.

The same reference numerals in FIGS. 8 and 11 denote the same elements, and thus repeated descriptions thereof are omitted.

Referring to FIG. 11, the display apparatus 1 may include a first encapsulation layer 511, a first adhesive layer 522, a first substrate 531, a second substrate 532, a light-emitting diode 540, a first electrode pad 551, a second electrode pad 552, a planarization insulating layer 560, a connection electrode CM, a second voltage line VSSL, a gate insulating layer 570, a buffer layer 580, transistor TR, a wiring WL, a third substrate 533, a second adhesive layer 523, and a second encapsulation layer 512.

The first encapsulation layer 511 may be disposed below the first substrate 531 to support the first substrate 531.

The first adhesive layer 522 may be disposed on the first encapsulation layer 511. The first adhesive layer 522 may be in direct contact with an upper surface of the first encapsulation layer 511 and a lower surface of the first substrate 531. The first adhesive layer 522 may attach the first encapsulation layer 511 to the first substrate 531.

The first substrate 531 is able to elongate and may be disposed on the first encapsulation layer 511. The first adhesive layer 522 may be interposed between the first substrate 531 and the first encapsulation layer 511. An opening 531OP having the same shape as that of the first opening CS1 may be defined in the first substrate 531. The first substrate 531 may include a transparent material.

The second substrate 532 is able to elongate and may be disposed on the first substrate 531. An opening 532OP having the same shape as that of the first opening CS1 may be defined in the second substrate 532.

At least a portion of the light-emitting diode 540 may be accommodated in the second substrate 532. The light-emitting diode 540 may be disposed inside the second substrate 532, within the first island portion 11. The light-emitting diode 540 may include a first semiconductor layer 541, a second semiconductor layer 542, an intermediate layer 543, a first electrode 544, and a second electrode 545.

As shown in FIG. 11, the light-emitting diode 540 may be spaced apart from the first substrate 531. In an alternative embodiment, unlike shown in FIG. 11, the light-emitting diode 540 may contact the first substrate 531. In this case, the first substrate 531 may include a transparent material. The second electrode 532 may include a transparent or opaque material. Light emitted from the light-emitting diode 540 may sequentially pass through the first substrate 531, the first adhesive layer 522, and the first encapsulation layer 511 and may be displayed on the outside. Even when the second substrate 532 includes opaque material, because the light-emitting diode 540 and the first substrate 531 contact each other, light emitted by the light-emitting diode 540 may be displayed to the outside.

The first electrode pad 551 may be disposed on the second substrate 532 to be electrically connected to the light-emitting diode 540. The second electrode pad 552 may be disposed on the second substrate 532 to be electrically connected to the light-emitting diode 540. The first electrode pad 551 and the second electrode pad 552 may each be disposed in the first island portion 11.

The planarization insulating layer 560 may be disposed on the second substrate 532 to cover the first electrode pad 551 and the second electrode pad 552. The planarization insulating layer 560 may include a first planarization insulating layer 561 and a second planarization insulating layer 562.

Openings 561OP and 562OP each having the same shape as that of the first opening CS1 may be defined in the planarization insulating layer 560. In other words, the opening 561OP having the same shape as that of the first opening CS1 may be defined in the first planarization insulating layer 561. The opening 562OP having the same shape as that of the first opening CS1 may be defined in the second planarization insulating layer 562.

The connection electrode CM and the second voltage line VSSL may be disposed between the first planarization insulating layer 561 and the second planarization insulating layer 562.

The gate insulating layer 570 may be disposed on the planarization insulating layer 560. An opening 570OP having the same shape as that of the first opening CS1 may be defined in the gate insulating layer 570.

The buffer layer 580 may be disposed on the gate insulating layer 570. An opening 580OP having the same shape as that of the first opening CS1 may be defined in the buffer layer 580.

The transistor TR may be disposed on the planarization insulating layer 560 and may be electrically connected to the first electrode pad 551. The transistor TR may be disposed in the first island portion 11. The transistor TR may include an active layer ACT and a gate electrode GE.

The active layer ACT may be disposed between the planarization insulating layer 560 and the gate insulating layer 570. The active layer ACT may be disposed on the planarization insulating layer 560, and the gate insulating layer 570 may cover the active layer ACT. The active layer ACT may include polysilicon. In an alternative embodiment, the active layer ACT may include amorphous silicon, an oxide semiconductor, an organic semiconductor, or the like. The active layer ACT may include a channel region C and a drain region D and a source region S respectively arranged on opposite sides of the channel region C. In this case, the connection electrode CM may electrically connect the source region S to the first electrode pad 551.

The gate electrode GE may be disposed between the gate insulating layer 570 and the buffer layer 580. The gate electrode GE may be disposed on the gate insulating layer 570, and the buffer layer 580 may cover the gate electrode GE. In other words, the transistor TR may be provided as a bottom gate type in which the gate electrode GE is disposed between the third substrate 533 and the active layer ACT. The gate electrode GE may overlap the channel region C. In this structure, because the gate electrode GE may protect the active layer ACT, the reliability of the display apparatus 1 may be improved.

The wiring WL may be disposed in the first bridge portion 12.

The third substrate 533 is able to elongate and may be disposed on the buffer layer 580. In other words, the third substrate 533 may be disposed on the transistor TR. An opening 533OP having the same shape as that of the first opening CS1 may be defined in the third substrate 533.

The second adhesive layer 523 may be disposed on the third substrate 533. The second adhesive layer 523 may be in direct contact with an upper surface of the third substrate 533 and a lower surface of the second encapsulation layer 512. The second adhesive layer 523 may attach the third substrate 533 to the second encapsulation layer 512. The second encapsulation layer 512 may be disposed on the third substrate 533.

The display apparatus 1 according to the above-described embodiments may be used in various electronic apparatuses capable of providing images. Here, an electronic apparatus refers to an apparatus that uses electricity and is capable of providing a predetermined image.

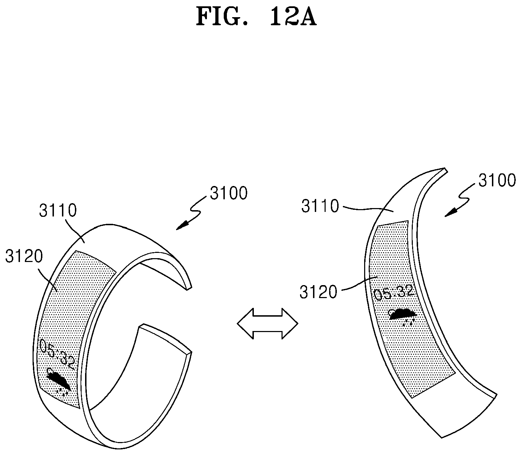

FIGS. 12A through 12G are schematic perspective views of embodiments of an electronic apparatus including a display apparatus.

Referring to FIG. 12A, the display apparatus in an embodiment may be utilized in a wearable electronic apparatus 3100 that may be worn on a portion of a user's body. The wearable electronic apparatus 3100 may include a body portion 3110 and a display 3120 provided in the body portion 3110. The display apparatus in embodiments may be used as the display 3120 of the wearable electronic apparatus 3100. As shown in FIG. 12A, the wearable electronic apparatus 3100 may be transformed. In an embodiment, the wearable electronic apparatus 3100 may be used as a smartwatch or a smartphone according to the user's selection.

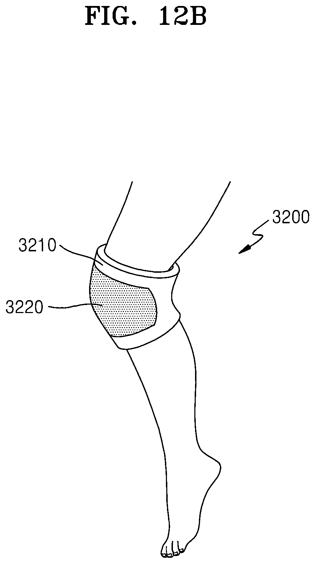

FIG. 12B shows a medical electronic apparatus 3200. In an embodiment, the medical electronic apparatus 3200 may include a body portion 3210 and an emission portion 3220. The display apparatus in embodiments may be used as the emission portion 3220 of the medical electronic apparatus 3200. The emission portion 3220 may emit light in a predetermined wavelength band (e.g., an infrared ray or a visible ray) to a patient's body. In an embodiment, the body portion 3210 may have a stretchable fiber material, and may have a structure that may be worn on the body of the user who uses the emission portion 3220.

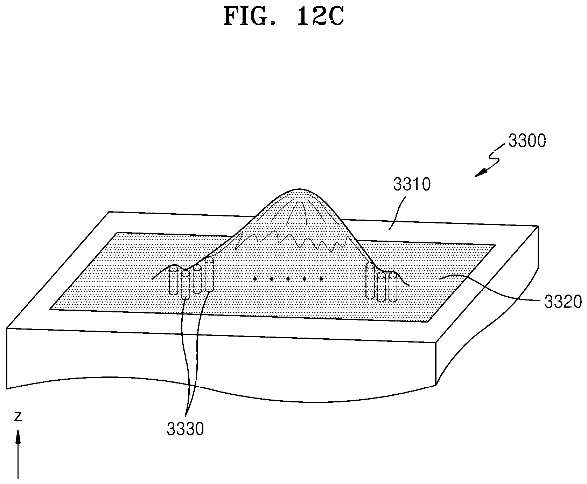

FIG. 12C shows an educational electronic apparatus 3300. In an embodiment, the educational electronic apparatus 3300 may include a display 3320 provided inside a frame 3310. The display 3320 may use the display apparatus. Images such as sea with waves, a mountain covered with snow, or a volcano with flowing lava may be provided through the display 3320, and in this case, the display 3320 may extend in a height direction (e.g., a z direction) to reflect the height of waves, mountains, or volcanoes. In some embodiments, because the height of a portion of the display 3320 sequentially varies in a direction in which the lava flows, the display 3320 may show the movements of lava three-dimensionally. The educational electronic apparatus 3300 may include a plurality of pins 3330 (or stroke portions) disposed on the backside of the display 3320 such that the display 3320 extends in the height direction. As the pins 3330 move in the third direction (e.g., a z direction or a -z direction), the image displayed on the display 3320 may be implemented to have a three-dimensional height. Although FIG. 12C describes the educational electronic apparatus 3300, the purpose of the electronic apparatus is not limited as long as the electronic apparatus provides predetermined image information.

Although the electronic apparatuses shown in FIGS. 12A through 12G are described as electronic apparatuses whose shapes are variable, the disclosure is not limited thereto. As in embodiments described below, the display apparatus in embodiments may be used in an electronic apparatus in which a portion (e.g., a screen) capable of displaying images is fixed.

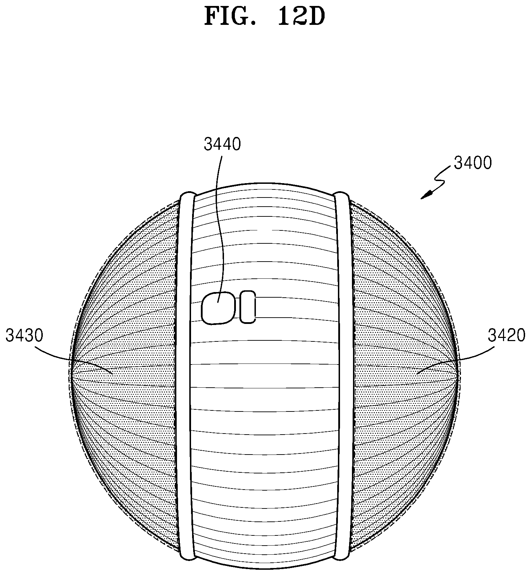

FIG. 12D shows a robot 3400 as an electronic apparatus. The robot 3400 may recognize an object or move by a camera 3440, and may display predetermined images to a user through displays 3420 and 3430. In some embodiments, because display apparatuses in an embodiment may be stretched in various directions as described above, the display apparatuses may be assembled to a body frame having a hemispherical shape, and thus, the robot 3400 may include the displays 3420 and 3430 each having a hemispherical shape.

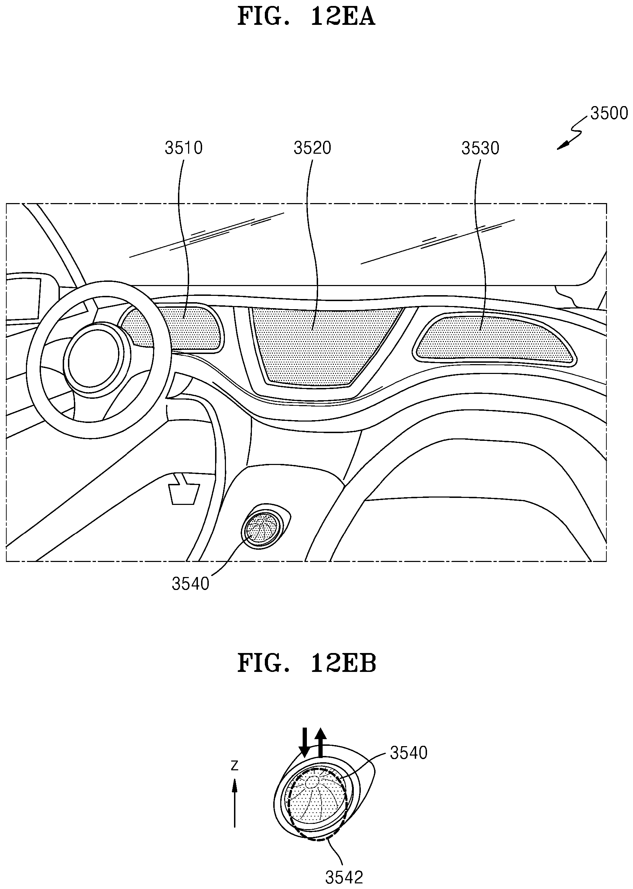

FIG. 12EA shows a vehicle display apparatus 3500 as an electronic apparatus. The vehicle display apparatus 3500 may include a cluster 3510, a center information display ("CID") 3520, and/or a co-driver display 3530. Because the display apparatus in an embodiment may be stretched in various directions, the display apparatus may be used as the cluster 3510, the CID 3520, and/or the co-driver display 3530 regardless of the shape of an internal frame of the vehicle.

Although it is shown in FIG. 12EA that the cluster 3510, the CID 3520, and/or the co-driver display 3530 are separated from each other, the disclosure is not limited thereto. In another embodiment, two or more of the cluster 3510, the CID 3520, and the co-driver display 3530 may be integrally connected to each other.

In some embodiments, the vehicle display apparatus 3500 may include a button 3540 that may display predetermined images. Referring to an enlarged view of FIG. 12EB, the button 3540 having a hemispherical shape may include an object 3542 that provides the feeling of using the button while moving in the z direction or -z direction, and a display apparatus disposed on the object 3542. In some embodiments, when the object 3542 has a surface rounded three-dimensionally, the display apparatus may also have a surface rounded three-dimensionally.

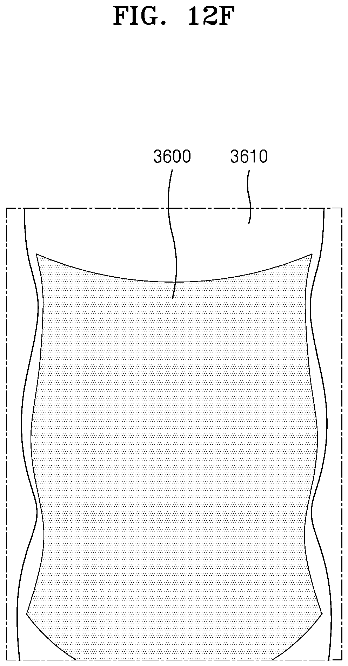

FIG. 12F shows that the electronic apparatus in an embodiment is an electronic apparatus 3600 for advertising or exhibition. In some embodiments, the electronic apparatus 3600 for advertising or exhibition may be installed on a structure 3610 such as a wall or pillar. When the structure 3610 includes an uneven surface as shown in FIG. 12F, the electronic apparatus 3600 for advertising or exhibition may also be disposed along the uneven surface of the structure 3610. In some embodiments, the electronic apparatus 3600 for advertising or exhibition may be installed on the structure 3610 by a heat shrink film or the like.

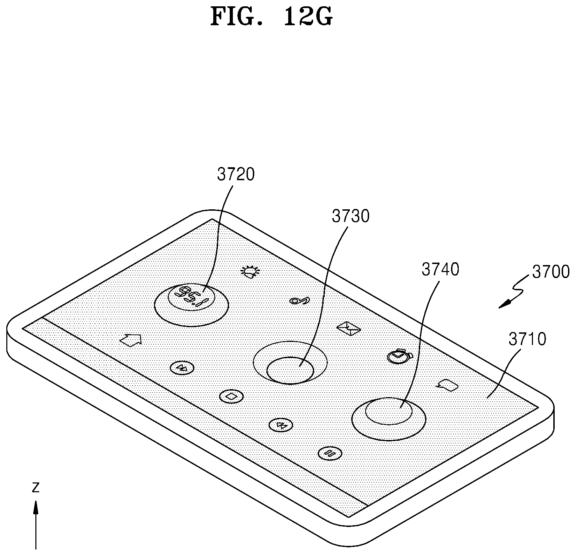

FIG. 12G shows that the electronic apparatus in an embodiment is a controller 3700. The controller 3700 may include an image type button. In an embodiment, the controller 3700 may include first, second, and third bottom regions 3720, 3730, and 3740 in which a partial region of a display 3710 protrudes in a z direction or -z direction (or is recessed in the z direction), for example. In some embodiments, the first and third button regions 3720 and 3740 may each protrude in the z direction, and the second button region 3730 may protrude in the -z direction (or be recessed in the z direction).

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the spirit and scope as defined by the following claims.

## Claims

1. A display apparatus comprising:
a first substrate;
a second substrate disposed on the first substrate;
a light-emitting diode at least partially accommodated in the second substrate;
a first electrode pad disposed on the second substrate and electrically connected to the light-emitting diode;
a planarization insulating layer disposed on the second substrate and covering the first electrode pad;
a transistor disposed on the planarization insulating layer and electrically connected to the first electrode pad; and
a third substrate disposed on the transistor.

2. The display apparatus of claim 1, wherein the transistor comprises:
an active layer including a channel region, a drain region, and a source region; and
a gate electrode overlapping the channel region.

3. The display apparatus of claim 2, wherein the gate electrode is disposed between the light-emitting diode and the active layer.

4. The display apparatus of claim 2, wherein the gate electrode is disposed between the third substrate and the active layer.

5. The display apparatus of claim 1, wherein
the light-emitting diode is spaced apart from the first substrate, and
each of the first substrate and the second substrate includes a transparent material.

6. The display apparatus of claim 1, wherein
the light-emitting diode contacts the first substrate, and
the first substrate comprises a transparent material.

7. The display apparatus of claim 1, wherein light transmittance of the first substrate is different from light transmittance of the second substrate.

8. The display apparatus of claim 1, further comprising a first encapsulation layer disposed below the first substrate and supporting the first substrate.

9. The display apparatus of claim 1, further comprising a second encapsulation layer disposed on the third substrate.

10. A method of manufacturing a display apparatus, the method comprising:
disposing a second substrate on a first substrate;
disposing a light-emitting diode within the second substrate;
curing the second substrate;
disposing a first electrode pad on the second substrate to be electrically connected to the light-emitting diode;
disposing a planarization insulating layer on the second substrate to cover the first electrode pad;
disposing a transistor on the planarization insulating layer to be electrically connected to the first electrode pad; and
disposing a third substrate on the transistor.

11. The method of claim 10, further comprising:
disposing the first substrate on a carrier substrate; and
curing the first substrate.

12. The method of claim 11, further comprising:
attaching a carrier film onto the third substrate;
removing the carrier substrate from the first substrate;
attaching a first encapsulation layer to the first substrate; and
removing the carrier film from the third substrate.

13. The method of claim 10, further comprising defining a first opening to pass through the first substrate, the second substrate, the planarization insulating layer, and the third substrate.

14. The method of claim 10, further comprising attaching a second encapsulation layer to the third substrate.

15. The method of claim 10, wherein the disposing the transistor comprises:
disposing an active layer including a channel region, a drain region, and a source region; and
disposing a gate electrode to overlap the channel region.

16. The method of claim 15, wherein the gate electrode is disposed between the light-emitting diode and the active layer.

17. The method of claim 15, wherein the gate electrode is disposed between the third substrate and the active layer.

18. The method of claim 10, wherein
the disposing the light-emitting diode comprises disposing the light-emitting diode to be spaced apart from the first substrate, and
each of the first substrate and the second substrate comprises a transparent material.

19. The method of claim 10, wherein
the disposing the light-emitting diode comprises disposing the light-emitting diode to contact the first substrate, and
the first substrate comprises a transparent material.

20. The method of claim 10, wherein light transmittance of the first substrate is different from light transmittance of the second substrate.
